(19) Europäisches Patentamt
European Patent Office
Office européen des brevets

(11) EP 3 846 209 B1

(12) **FASCICULE DE BREVET EUROPEEN**

(45) Date de publication et mention de la délivrance du brevet:
**18.05.2022 Bulletin 2022/20**

(21) Numéro de dépôt: **20216307.7**

(22) Date de dépôt: **22.12.2020**

(51) Classification Internationale des Brevets (IPC):
***H01L 27/144*** *(2006.01)* ***H01L 27/146*** *(2006.01)*
***H01L 31/0216*** *(2014.01)*

(52) Classification Coopérative des Brevets (CPC):
**H01L 27/1446; H01L 27/14623; H01L 31/02164;**
H01L 27/14669; H01L 27/14696

(54) **COMPOSANT DE DÉTECTION INCLUANT DES PIXELS NOIRS ET PROCÉDÉ DE FABRICATION D'UN TEL COMPOSANT**

SENSORBAUTEIL MIT SCHWARZEN PIXELN, UND VERFAHREN ZUR HERSTELLUNG EINES SOLCHEN BAUTEILS

DETECTION COMPONENT INCLUDING BLACK PIXELS AND METHOD FOR MANUFACTURING SUCH A COMPONENT

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **30.12.2019 FR 1915735**

(43) Date de publication de la demande:
**07.07.2021 Bulletin 2021/27**

(73) Titulaire: **Commissariat à l'énergie atomique et aux énergies alternatives**
**75015 Paris (FR)**

(72) Inventeurs:
- **LE PERCHEC, Jérôme**
  **38054 GRENOBLE CEDEX 09 (FR)**
- **BADANO, Giacomo**
  **38054 GRENOBLE CEDEX 09 (FR)**

(74) Mandataire: **Brevalex**
**95, rue d'Amsterdam**
**75378 Paris Cedex 8 (FR)**

(56) Documents cités:
**WO-A1-2019/004319 US-B1- 9 698 192**

- **CHIH-MING WANG ET AL: "Plasmonic Infrared Bandstop Reflective Filter", IEEE JOURNAL OF SELECTED TOPICS IN QUANTUM ELECTRONICS, IEEE SERVICE CENTER, PISCATAWAY, NJ, US, vol. 19, no. 3, 1 mai 2013 (2013-05-01), page 4601005, XP011513265, ISSN: 1077-260X, DOI: 10.1109/JSTQE.2012.2228256**
- **PALANCHOKE UJWOL ET AL: "CMOS-compatible metallic nanostructures for visible and infrared filtering", PROCEEDINGS OF SPIE, IEEE, US, vol. 8994, 19 février 2014 (2014-02-19), pages 89940Y-89940Y, XP060036136, DOI: 10.1117/12.2037665 ISBN: 978-1-62841-730-2**

Il est rappelé que: Dans un délai de neuf mois à compter de la publication de la mention de la délivrance du brevet européen au Bulletin européen des brevets, toute personne peut faire opposition à ce brevet auprès de l'Office européen des brevets, conformément au règlement d'exécution. L'opposition n'est réputée formée qu'après le paiement de la taxe d'opposition. (Art. 99(1) Convention sur le brevet européen).

## Description

### Domaine technique

L'invention concerne le domaine des composants de détection de rayonnement électromagnétique et notamment ceux visant la détection de rayonnement électromagnétique dans les plages de longueurs d'onde de l'infrarouge.

Ainsi l'invention a pour objet un composant de détection de rayonnement électromagnétique et un procédé de fabrication d'un tel composant.

### État de l'art antérieur

Dans le cadre d'applications de détection de faibles signaux électromagnétiques, telles que pour les composants de détection de rayonnement infrarouge spatial, afin de mieux identifier signal photonique utile vis-à-vis du bruit, il est connu, notamment du document US 10326952, de prévoir un masque opaque au-dessus de certains pixels de détection de ces composants afin de mesurer, à partir de ces pixels recouverts, un courant d'obscurité. Le document WO2019/004319 décrit un composant de détection de rayonnement électromagnétique selon l'art antérieur.

Ainsi, avec une telle configuration enseignée par le document US 10326952, permettant de déterminer le courant d'obscurité et donc le signal de bruit, il est possible d'identifier le signal pertinent sortant de ce bruit.

Néanmoins, sans précision sur la configuration du masque dans le document US 10326952, si ce n'est qu'il est possible de fournir, avec un matériau adéquat (il est fait mention de chrome), un masque d'une épaisseur réduite à 1 $\mu$m, un masque tel qu'enseigné par ce document est généralement métallique et présente une épaisseur relativement importante, c'est-à-dire supérieure ou égale à 1 $\mu$m.

Ainsi, dans le cas d'un composant de détection selon une configuration considérée dans laquelle le composant comprend un support comprenant une couche, dite couche active, dans laquelle est aménagée une pluralité de structures de détection de rayonnement électromagnétique, le support comprenant une première face à partir de laquelle s'étend la couche active, et une deuxième face, opposée à la première face par laquelle le support est destiné à recevoir le rayonnement électromagnétique, et un masque agencé sur la deuxième face, les phénomènes suivants sont observés :

- d'ombrage en raison de l'épaisseur relativement importante des masques,
- de la diffraction liée aux bords du masque et qui est à l'origine de fuite photonique en direction des structures masquées,
- de la réflexion parasite dans l'enceinte contenant le composant et qui peut être à l'origine de signaux parasites.

On notera, de plus, que dans le cas des composants de détection de rayonnement infrarouge basse température, en raison des contraintes thermiques auxquelles ils sont soumis, peuvent présenter, pour des masques opaques de relatives grandes épaisseurs, des risques importants de dégradations et de décollement. Dans une telle utilisation, l'utilisation de masques opaques de relatives faibles épaisseurs devrait permettre de limiter les risques de dégradations et de décollement.

### Exposé de l'invention

L'invention a pour but de résoudre au moins en partie les inconvénients ci-dessus et vise ainsi à fournir un composant de détection qui, présentant la configuration considérée, ne soit que partiellement, voire nullement, soumis aux phénomènes de réflexions parasites présents dans le cas de l'art antérieur. L'invention vise également, notamment dans le cadre de composants de détection destinés à fonctionner à basse température, à fournir un composant de détection qui puisse présenter un masque opaque moins sensible aux risques dégradations et de décollement lorsque le composant est soumis à de basse température.

L'invention concerne à cet effet un composant de détection de rayonnement électromagnétique dans une plage de longueurs d'onde comprenant :

- un support comprenant une couche, dite couche active, dans laquelle est aménagée une pluralité de structures de détection de rayonnement électromagnétique dans ladite plage de longueurs d'onde, le support comprenant une première face à partir de laquelle s'étend la couche active, et une deuxième face, opposée à la première face par laquelle le support est destinée à recevoir le rayonnement électromagnétique,
- au moins un masque, dit masque opaque, agencé sur une portion de la deuxième face du support pour occulter le rayonnement électromagnétique pour au moins une des structures de détection, dite structure masquée.

Le masque opaque comprend au moins un premier, un deuxième et ,un troisième métal et un matériau, dit matériau transparent d'indice de réfraction inférieur ou égal à 2 dans la plage de longueurs d'onde, le premier métal présentant un coefficient d'extinction $k_{m1}$ supérieur ou égal $5n_{m1}$, voire à $10n_{m1}$, et le deuxième et le troisième métal présentant chacun un coefficient d'extinction $k_{m2/3}$ strictement inférieur à $5n_{m2/3}$, voire inférieur ou égal à $2n_{m2/3}$ avec $n_{m1}$ et $n_{m2/3}$ les indices de réfraction du premier et dudit deuxième et troisième métal dans la plage de longueurs d'onde, le matériau transparent présentant un coefficient d'extinction $k_t$ inférieur ou égal à 0,01.

Le masque opaque comprend, à partir de la deuxième face du support, un empilement successif:

- d'une première couche métallique réalisée dans le premier métal,
- d'une deuxième couche métallique réalisée dans le deuxième métal,
- d'une troisième couche, dite couche transparente, réalisée dans le matériau transparent, et
- d'un ensemble d'éléments métalliques réalisés dans le troisième métal, ledit ensemble étant agencé sur la couche transparente à l'opposé de la deuxième couche métallique,

et dans lequel la deuxième couche métallique, la couche transparente et l'ensemble de d'éléments métalliques forment des structures MIM dans la plage de longueurs d'onde.

Ainsi, selon l'invention, les coefficients d'extinction $k_{m2}$ et $k_{m3}$ du deuxième et du troisième métal peuvent répondre à au moins une des inégalités suivantes vis-à-vis de respectivement des indices de réfraction $n_{m2}$, $n_{m3}$ du deuxième et troisième métal :

- $k_{m2/3} < 5n_{m2/3}$,
- $k_{m2/3} \leq 4n_{m2/3}$,$k_{m2/3} \leq 2n_{m2/3}$.

Avec une telle combinaison de structures MIM à base de métaux « absorbants », c'est-à-dire présentant un coefficient d'extinction $k_{m2}$ strictement inférieur à $5n_{m2}$, et d'une couche réflectrice à base de métal « réfléchissant », c'est-à-dire un métal présentant un coefficient d'extinction $k_{m1}$ supérieur ou égal $5n_{m1}$, permet de bénéficier à la fois des propriétés d'occultation fournies par le premier métal et la première couche qui en est formée, et des propriétés antireflet fournies par la structure MIM dans la plage de longueurs d'onde. Ainsi, il est possible de fournir un masque de faible épaisseur, limitant le phénomène d'ombrage qu'un tel masque pourrait occasionner, et peu, voire pas, réfléchissant, limitant ainsi les risques de réflexions parasites dans l'environnement proche du composant de détection et donc les signaux parasites qui y sont associés.

De plus, un tel masque opaque pouvant présenter un masque opaque épaisseur relativement faible vis-à-vis des masques opaques de l'art antérieur, tels que celui divulgué par le document US 10326952, le masque opaque d'un composant selon l'invention présente des risques dégradations et de décollement relativement faible lorsque le composant est soumis à de basse température.

Il est rappelé qu'un métal est caractérisé par une permittivité électrique $\varepsilon = (n+ik)^2$ avec n l'indice de réfraction dudit métal et k le coefficient d'extinction. A partir de cette valeur, il est possible de calculer une épaisseur de peau $\delta$ à une longueur d'onde $\lambda$ donnée à partir de l'expression suivante : $\delta = \lambda/(2\pi k)$.

Les structures MIM, pour structure Métal/Isolant/Métal sont des cavités horizontales multicouches notamment utilisées dans le cadre des antennes. Une structure MIM comprend une première couche métallique revêtue d'une couche transparente, généralement diélectrique, et un élément métallique, tel qu'un plot métallique, réalisé préférentiellement dans le même métal que ladite première couche métallique. Dans l'application classique de telles structures MIM, où on exploite des résonnances de cavité relativement sélectives en longueur d'onde, le métal de la première couche métallique et de l'ensemble d'éléments métalliques est un métal présentant une bonne réflectivité, c'est-à-dire pour lequel le coefficient d'extinction dans la longueur d'onde considéré est supérieur à 10 fois l'indice de réfraction ce même métal à la longueur d'onde considérée. Plus d'informations concernant de telles structures MIM peuvent être notamment trouvé dans l'article publié en 2006 par A.P. Hibbins et ses coauteurs dans la revue scientifique « Physical Review B » Numéro 74 pages 073408.

Le deuxième et le troisième métal peuvent être identiques.

Avec une telle configuration, le taux d'absorption de la structure MIM s'en trouve optimisé.

La première couche métallique peut présenter une épaisseur $h_{m1}$ supérieure à 2 fois une épaisseur de peau $\delta_{m1}$ du premier métal dans la plage de longueurs d'onde, l'épaisseur de la première couche métallique étant préférentiellement supérieure à 4 fois l'épaisseur de peau $\delta_{m1}$ du premier métal dans la plage de longueurs d'onde.

De cette manière, le masque opaque présente un taux de transmission particulièrement faible, voire sensiblement nul.

La deuxième couche métallique peut présenter une épaisseur $h_{m2}$ comprise entre 0,5 fois une épaisseur de peau $\delta_{m2}$ du deuxième métal dans la plage de longueurs d'onde et à 4 fois l'épaisseur de peau $\delta_{m2}$ du deuxième métal dans la plage de longueurs d'onde, l'épaisseur de la première couche métallique étant préférentiellement supérieure à 4 fois l'épaisseur de peau $\delta_{m1}$ du premier métal dans la plage de longueurs d'onde.

Les éléments métalliques peuvent présenter, selon un plan sensiblement parallèle à la deuxième face, au moins une dimension latérale L inférieure ou égale à une valeur Lm respectant l'équation suivante :

$$Lm = \frac{\lambda_0}{2\, n_d \sqrt{(1+\frac{2\delta_{m2}}{h_d})}}$$

avec $\lambda_0$ une longueur d'onde centrale de la plage de longueurs d'onde, $n_d$ un indice de réfraction du matériau transparent à ladite longueur d'onde, centrale $h_d$ une épaisseur de la couche transparente et $\delta_{m2}$ une épaisseur de peau du deuxième métal à ladite longueur d'onde,

les éléments métalliques présentant préférentiellement une dimension latérale maximale et une dimension latérale minimale, selon un plan sensiblement parallèle à la deuxième face, comprises entre 0,75 fois ladite valeur Lm et 1,25 fois la valeur Lm.

Les structures MIM sont ainsi particulièrement adaptées pour la plage de longueur d'onde.

Dans l'ensemble d'éléments métalliques, deux éléments métalliques adjacents présentent entre eux une distance inter-barycentre inférieure ou égal à $\lambda_0/n_d$, $\lambda_0$ étant une longueur d'onde centrale de la plage de longueurs d'onde et $n_d$ l'indice de réfraction du matériau transparent dans la plage de longueurs d'onde, le pas P entre deux éléments métalliques adjacents dans l'ensemble d'éléments métalliques étant préférentiellement inférieur à 0,75 fois $\lambda_0/n_d$.

Les éléments métalliques de l'ensemble d'éléments métalliques peuvent être agencés périodiquement avec un pas P entre les éléments métalliques inférieur à $\lambda_0/n_d$, ledit pas P entre les entre les éléments métalliques étant préférentiellement inférieur à 0,75 fois $\lambda_0/n_d$.

La couche transparente peut présenter une épaisseur comprise entre $\lambda_0/4n_d$ et $\lambda_0/50n_d$, les valeurs $\lambda_0/4n_d$ et $\lambda_0/50n_d$ étant incluses, $\lambda_0$ étant une longueur d'onde centrale de la plage de longueurs d'onde et $n_d$ l'indice de réfraction du matériau transparent dans la plage de longueurs d'onde.

L'épaisseur de la couche transparente peut être comprise entre $\lambda_0/4n_d$ et $\lambda_0/25n_d$, avec les valeurs $\lambda_0/4n_d$ et $\lambda_0/25n_d$ incluses.

Chaque élément métallique de l'ensemble de d'éléments métalliques peut présenter une épaisseur, dans le sens d'empilement du masque opaque, qui est comprise entre une fois une épaisseur de peau $\delta_{m2}$ du troisième métal dans la plage de longueurs d'onde et trois fois ladite épaisseur de peau $\delta_{m2}$ du deuxième métal, l'épaisseur de chaque élément métallique étant préférentiellement comprise entre une fois et demie l'épaisseur de peau $\delta_{m2}$ du troisième métal dans la plage de longueurs d'onde et deux fois et demie ladite épaisseur de peau $\delta_{m2}$ du troisième métal.

Avec de tels paramètres des structures MIM, le taux de réflexion du masque opaque est particulièrement faible voire sensiblement nul.

Le masque opaque peut être agencé sur la deuxième face du support pour occulter le rayonnement électromagnétique pour l'au moins une structure masquée et les structures de détection adjacentes à ladite au moins une structure masquée.

Avec un tel agencement on limite l'éventuelle collecte de photo-porteurs depuis les structures adjacentes vers la structure masqué qui pourrait avoir lieu du fait du cross-talk électrique classique entre pixels adjacents.

Le masque opaque peut être agencé sur la deuxième face du support pour également occulter le rayonnement électromagnétique les structures de détection adjacentes auxdites structures de détection adjacentes à ladite au moins une structure masquée.

Avec un tel agencement les risques d'éventuelle collecte de photo-porteurs depuis les structures adjacentes sont sensiblement nuls.

Le support peut présenter une épaisseur inférieure à 10 µm, le masque opaque s'étendant, de part est d'autre d'une projection de la structure masquée sur la deuxième face du support sur une distance supérieure à 15 µm et préférentiellement supérieure à 30 µm.

Les structures de détection de la pluralité de structure de détection peuvent être agencées selon une matrice définissant des lignes et des colonnes de structure de détection, le masque opaque est agencé pour occulter le rayonnement électromagnétique pour des structures de détection d'une même ligne ou colonne.

L'invention concerne en outre un procédé de fabrication d'un composant de détection de rayonnement électromagnétique dans une plage de longueurs comprenant les étapes suivantes :

- fourniture d'un support comprenant une couche, dite couche active, dans laquelle est aménagée une pluralité de structures de détection de rayonnement électromagnétique dans ladite plage de longueurs d'onde, le support comprenant une première face à partir de laquelle s'étend la couche active, et une deuxième face, opposée à la première face par laquelle le support est destinée à recevoir le rayonnement électromagnétique,
- formation d'un masque opaque comprenant, à partir de la deuxième face du support, un empilement successif:

  o d'une première couche métallique réalisée dans un premier métal,
  o d'une deuxième couche métallique réalisée dans un deuxième métal,
  o d'une troisième couche, dite couche transparente, réalisée dans un matériau dit matériau transparent d'indice de réfraction inférieur ou égal à 2 dans la plage de longueurs d'onde, et
  o d'un ensemble d'éléments métalliques réalisés dans un troisième métal, ledit ensemble étant agencé sur la couche transparente à l'opposé de la deuxième couche métallique, la deuxième couche métallique, la couche transparente et l'ensemble de d'éléments métalliques formant des structures MIM dans la plage de longueurs d'onde,

  le masque opaque étant agencé sur une portion de la deuxième face du support pour occulter le rayonnement électromagnétique pour au moins une des structures de détection, dite structure masquée,

  dans lequel procédé le masque opaque comprend le premier le deuxième et le troisième métal et le matériau, dit matériau transparent, le premier métal présentant un coefficient d'extinction $k_{m1}$ supérieur ou égal $5n_{m1}$, voire à $10n_{m1}$, et les deuxième et troisième métaux présentant

chacun un coefficient d'extinction $k_{m2/3}$ strictement inférieur à $5n_{m2/3}$, voire inférieur ou égal à $2n_{m2/3}$ avec $n_{m1}$ et $n_{m2/3}$ les indices de réfraction du premier et de chacun desdits deuxième et troisième métaux dans la plage de longueurs d'onde, le matériau transparent présentant un coefficient d'extinction $k_t$ inférieur ou égal à 0,01.

Un tel procédé permet la fabrication d'un composant de détection selon l'invention et de bénéficier des avantages qui y sont liés.

L'étape de formation comprend les sous étapes suivantes :

- dépôt de la première couche métallique réalisée dans le premier métal en contact de la deuxième face du support,
- dépôt de la deuxième couche métallique réalisée dans le deuxième métal en contact avec la première couche métallique,
- dépôt de la couche transparente, réalisée dans le matériau transparent en contact avec la deuxième couche métallique, la troisième couche étant dite couche transparente,
- formation d'un ensemble d'éléments métalliques réalisés dans le troisième métal sur la couche transparente à l'opposé de la deuxième couche métallique.

Lors de l'étape de formation du masque opaque, le masque est agencé sur la deuxième face du support pour occulter le rayonnement électromagnétique pour l'au moins une structure masquée et les structures de détection adjacentes à ladite au moins une structure masquée.

De cette manière, un composant fabriqué avec un tel procédé présente, en fonctionnement, une structure masquée peu, voire pas, exposé aux courants de fuites qui pourraient être générées par les structures adjacentes si ces dernières étaient soumises au rayonnement électromagnétique.

## Brève description des dessins

La présente invention sera mieux comprise à la lecture de la description d'exemples de réalisation, donnés à titre purement indicatif et nullement limitatif, en faisant référence aux dessins annexés sur lesquels :

- la figure 1 illustre une vue en coupe latérale du composant de détection selon l'invention,
- les figures 2A et 2B illustrent respectivement une vue en coupe latérale rapprochée d'un composant de détection montrant l'agencement d'un élément de masquage sur un composant de détection selon l'invention, et une vue de dessus de ce même élément de masquage,
- les figures 3A et 3B illustrent respectivement et graphiquement la variation de la réflectivité d'un élément de masquage selon l'invention en fonction de la longueur d'onde pour différentes incidences du rayonnement électromagnétique, et la variation de la réflectivité d'un élément de masquage selon une variante de l'invention en fonction de la longueur d'onde,
- la figure 4 illustre graphiquement le taux d'absorption d'une structure masquée en fonction de l'épaisseur du support divisé par l'indice réfraction du support ceci pour deux configurations du masque opaque de l'invention,
- les figure 5A et 5B illustre respectivement un premier et un deuxième exemple d'agencement d'éléments de masquage pour un composant de détection dans lequel il est prévu des structures masquées de référence,
- les figures 6A et 6B illustre une première et une deuxième variante d'un composant de détection selon le mode de réalisation principal de l'invention dans lesquels les structures métalliques forme des deuxièmes structures MIM,
- la figure 7 illustre graphiquement une comparaison de la variation de la réflectivité d'un masque opaque selon le mode réalisation principal l'invention avec la variation de la réflectivité d'un masque opaque selon la première variante du mode de réalisation principal.

Des parties identiques, similaires ou équivalentes des différentes figures portent les mêmes références numériques de façon à faciliter le passage d'une figure à l'autre.

Les différentes parties représentées sur les figures ne le sont pas nécessairement selon une échelle uniforme, pour rendre les figures plus lisibles.

Les différentes possibilités (variantes et modes de réalisation) doivent être comprises comme n'étant pas exclusives les unes des autres et peuvent se combiner entre elles.

## Description des modes de réalisation

La figure 1 illustre un composant de détection selon l'invention équipé d'un masque 140, dit opacifiant, agencé sur une portion de la deuxième face d'un support 110 du composant de détection 1 pour occulter totalement le rayonnement électromagnétique pour au moins une des structures de détection 122 dudit composant de détection 1.

Un tel composant de détection 1, qui est selon un mode de réalisation principal de l'invention, vise plus particulièrement la détection de rayonnement électromagnétique dans la gamme de longueurs d'onde des infrarouges. Ainsi, les différentes valeurs indiquées dans les modes de réalisation décrits ci-après concernent cette application pratique, dans laquelle la gamme de longueurs d'onde visée est dans une plage de longueur

d'onde de l'infrarouge moyen, par exemple une plage de longueurs d'onde comprise entre 2,5 et 3,5 μm. Bien entendu, l'homme du métier est parfaitement à même, à partir de la présente divulgation, d'adapter ces valeurs afin de permettre à l'aide d'une telle structure de détection 10 la détection optimisée de rayonnement électromagnétique dans une gamme de longueurs d'onde autre que celle des infrarouges. Dans ce cadre-là, l'invention est particulièrement avantageuse dans le cadre des applications à la détection de rayonnement électromagnétique dans les plages de longueurs d'onde de l'infrarouge basées sur les composants de détection fonctionnant à basse température, c'est-à-dire typiquement inférieure à -100°C ou 173 K, le plus souvent vers 80 K, comme c'est le cas pour les détecteurs à base de HgCdTe.

Un tel composant de détection 1 comporte :

- le support 110 comprenant une couche 120, dite couche active, dans laquelle est aménagée une pluralité de structures de détection 121a, 121b, 122, 123 de rayonnement électromagnétique λ dans ladite plage de longueurs d'onde, le support 110 comprenant une première face à partir de laquelle s'étend la couche active 120, et une deuxième face, opposée à la première face par laquelle le support 110 est destiné à recevoir le rayonnement électromagnétique λ,
- le masque opaque 140 agencé sur une portion de la deuxième face du support 110 pour occulter le rayonnement électromagnétique d'une structure de détection 122 qui est dite structure masquée.

Comme montré sur les figures 2A et 2B dans le cadre d'une variante de ce mode de réalisation dans lequel le masque opaque est agencé sur une portion de la deuxième face du support 110 exempte de revêtement antireflet 130, le masque opaque 140 comprend, à partir de la deuxième face du support 110, un empilement successif :

- d'une première couche métallique 141 réalisée dans un premier métal,
- d'une deuxième couche métallique 142 réalisée dans un deuxième métal,
- d'une troisième couche 143, dite couche transparente, réalisée dans un matériau transparent, et
- d'un ensemble d'éléments métalliques 144 réalisés dans le deuxième métal, ledit ensemble étant agencé sur la couche transparente 143 à l'opposé de la deuxième couche métallique 142.

La deuxième couche métallique 142, la couche transparente 143 et l'ensemble de d'éléments métalliques 144 forment des structures MIM dans la plage de longueurs d'onde.

Le premier métal présente un coefficient d'extinction $k_{m1}$ supérieur ou égal $5n_{m1}$ et le deuxième métal présente un coefficient d'extinction $k_{m2}$ strictement inférieur à $5n_{m2}$, voire inférieure ou égal à $2n_{m2}$ avec $n_{m1}$ et $n_{m2}$ les indices de réfraction du premier et du deuxième métal dans la plage de longueurs d'onde. D'une manière préférentielle, le premier métal présente un coefficient d'extinction $k_{m1}$ supérieur ou égal $10n_{m1}$.

On notera que selon une possibilité de l'invention, le deuxième métal peut présenter un coefficient d'extinction $k_{m2}$ inférieur ou égale à $4n_{m2}$.

Dans ce premier mode de réalisation, le premier support 110 est un support en tellurure de cadmium et de zinc CdZnTe comprenant la couche active 120 réalisée dans un tellurure de mercure cadmium HgCdTe. Chacune des structures de détection 121A, 121B, 122, 123 est par exemple une photodiode PN, conforme à celles mise en œuvre dans l'art antérieur, celles-ci étant montrées uniquement par leur empreinte volumique respective occupée dans la couche active.

Bien entendu, si dans ce premier mode de réalisation, chaque structure de détection 121A, 121B, 122, 123 est une photodiode PN, l'invention ne se limite à ce seul type de structures de détection. Ainsi, le composant peut, par exemple, comporter des photodiodes d'un autre type, tel que des photodiodes PiN (c'est-à-dire présentant une zone intrinsèque ménagée entre une zone N et une zone P), des diodes à avalanche ou à barrière, sans que l'on sorte du cadre de l'invention.

Le support 110 peut présenter une épaisseur comprise entre 1 et 20 μm, préférentiellement, entre 5 et 15 μm. Ainsi, par exemple, le support peut présenter une épaisseur de 10 μm.

La deuxième face du support 110 peut comprendre un revêtement antireflet 130 conformément à la pratique usuelle de l'homme du métier dans le cadre des composants de détection 1 de l'art antérieur. On notera que dans le présent mode de réalisation, comme illustré sur la figure 1, le masque opaque 140 est disposé sur la surface de ce revêtement antireflet 130. Néanmoins, selon une variante montrée sur les figures 2A et 2B, le masque opaque 140 peut être agencé sur une portion de la deuxième face du support 110 exempte de revêtement antireflet 130. En effet, de par les caractéristiques du masque opaque 140, une telle couche antireflet 130 n'est pas nécessaire pour les portions de deuxième face du support 100 recouvertes par un masque opaque 140.

Le masque opaque 140 est agencé sur la deuxième face du support 110, pour occulter le rayonnement électromagnétique pour au moins une des structures de détection 122, dite structure masquée. Afin de parfaire une telle occultation, comme partiellement montré sur la figure 1, le masque opaque 140 peut être agencé pour occulter le rayonnement électromagnétique pour au moins la structure masquée 122 et au moins une structure adjacente 123 de part et d'autre de celle-ci. Une telle occultation plus large, permet de limiter l'influence des effets diffractifs des bords de masque sur la structure masquée et de limiter l'éventuelle collecte de photo-porteurs depuis la zone 123 vers la structure 122 du fait du cross-talk électrique classique entre pixels adjacents.

Une telle configuration est explicitée plus en avant par la suite en lien avec la figure 2.

Dans le cadre d'une application de l'invention au proche infrarouge et au moyen infrarouge, la première couche métallique 141, peut être réalisée en or Au, en aluminium Al ou encore en cuivre Cu, voire un alliage de deux métaux, voire un alliage de ces trois métaux.

On notera que, notamment dans le cas où le premier métal est de l'or Au, il peut être prévu, entre la deuxième face du support 110 et la première couche métallique 141 une couche d'accroche de quelques nanomètres. Une telle couche d'accroche peut être, pour le premier métal qui est de l'or Au, réalisée en titane Ti ou en nickel Ni.

La première couche métallique 141 présente préférentiellement une épaisseur $h_{m1}$ supérieure à 2 fois une épaisseur de peau $\delta_{m1}$ du premier métal dans la plage de longueurs d'onde, l'épaisseur de la première couche métallique 141 étant préférentiellement supérieure ou égale à 4 fois l'épaisseur de peau $\delta_{m1}$ du premier métal dans la plage de longueurs d'onde. On notera, de plus que l'épaisseur de la première couche métallique est préférentiellement inférieure $10\delta_{m1}$.

Autrement dit, l'épaisseur $h_{m1}$ de la première couche métallique répond préférentiellement à l'inéquation $2\delta_{m1} < h_{m1} < 10\delta_{m1}$ et répond, de manière particulièrement avantageuse à l'inéquation suivante :

$$(2) \qquad 4\delta_{m1} \le h_{m1} < 2\delta_{m1}$$

Ainsi, par exemple, l'épaisseur $h_{m1}$ peut être sensiblement égale à $4\delta_{m1}$. Dans le cas où le premier métal est de l'or Au, l'or présentant, pour une longueur d'onde de 2,5 $\mu$m, un indice de réfraction de 1,24, un coefficient d'extinction de 15,7 et donc une épaisseur de peau $\delta_{m1}$ de 25 nm, on obtient donc une première couche métallique 141 d'une épaisseur de 100 nm.

Dans le cadre d'une application de l'invention au proche infrarouge et au moyen infrarouge, la deuxième couche métallique 142, peut être réalisée en titane Ti ou en platine Pt, ou en tungstène W, voire un alliage de titane et de platine.

La deuxième couche métallique 142 présente une épaisseur $h_{m2}$ comprise entre une 0,5 fois une épaisseur de peau $\delta_{m2}$ du deuxième métal dans la plage de longueurs d'onde et à 4 fois l'épaisseur de peau $\delta_{m2}$ du deuxième métal dans la plage de longueurs d'onde. Autrement dit, l'épaisseur de la deuxième couche métallique 142 répond à l'équation suivante :

$$(3) \qquad 0{,}5\delta_{m2} \le h_{m2} \le 2\delta_{m2}$$

Ainsi, par exemple, l'épaisseur $h_{m2}$ peut être de l'ordre de l'épaisseur de peau du deuxième métal. Dans le cas où le deuxième métal est du titane Ti, le titane Ti présente, pour une longueur d'onde de 2,5 $\mu$m, un indice de réfraction $n_{m2}$ 4,36, un coefficient d'extinction de $k_{m2}$ de 3,19 et donc une épaisseur de peau $\delta_{m2}$ du titane étant de 130 nm, on obtient donc une deuxième couche métallique 141 de l'ordre de 130 nm, c'est-à-dire entre 100 nm et 160 nm.

La couche transparente 143 est réalisée dans un matériau, dit matériau transparent, d'indice de réfraction inférieure ou égale à 2 dans la plage de longueur d'onde et présentant un coefficient d'extinction $k_t$ inférieur ou égal à 0,01 dans la plage de longueur d'onde. Dans une configuration classique de l'invention, la couche de matériau transparent est réalisée dans un matériau diélectrique, tel qu'un dioxyde de silicium $SiO_2$, de l'alumine $Al_2O_3$ et le fluorure de Magnésium $MgF_2$. En variante, la couche de matériau transparent 143 peut être réalisé dans un oxyde conducteur, tel qu'un oxyde d'indium et d'étain, plus connu sous le sigle ITO, un oxyde de zinc, plus connu sous le sigle ZnO et un oxyde de zinc dopé à l'aluminium, plus connu sous le sigle AZO. L'ensemble de ces matériaux présentent un coefficient d'extinction $k_t$ inférieur ou égal à 0,01 dans la plage de longueur d'onde.

On notera que, d'une manière préférentielle, le matériau de la couche transparente 143 présente un indice de réfraction inférieur ou égal à 1,5, ce qui est notamment le cas pour le dioxyde de silicium $SiO_2$, de l'alumine $Al_2O_3$ et le fluorure de Magnésium $MgF_2$.

La couche transparente 143 peut présenter une épaisseur $Ep_d$ comprise entre $\lambda_0/4n_d$ et $\lambda_0/50n_d$, les valeurs $\lambda_0/4n_d$ et $\lambda_0/50n_d$ étant incluses, $\lambda_0$ étant une longueur d'onde centrale de la plage de longueurs d'onde et $n_d$ l'indice de réfraction du matériau transparent 143 dans la plage de longueurs d'onde. Autrement dit l'épaisseur $Ep_d$ de la couche transparente 143 peut répondre aux inéquations suivantes :

$$(4) \qquad \frac{\lambda_0}{4n_d} \ge Ep_d \ge \frac{\lambda_0}{50n_d}$$

Ainsi, par exemple l'épaisseur $Ep_d$ de la couche transparente 143 peut être égale à $\lambda_0/10n_d$.

De la même manière, La couche transparente 143 peut présenter une épaisseur $Ep_d$ comprise entre $\lambda_0/4n_d$ et $\lambda_0/25n_d$, les valeurs $\lambda_0/4n_d$ et $\lambda_0/25n_d$ étant incluses.

L'ensemble d'éléments métalliques 144 sont agencés sur la troisième couche 143 et sont réalisés dans le deuxième métal. Chaque élément métallique 144 dudit ensemble se présente sous la forme d'un plot métallique pouvant prendre, par exemple et selon une projection sur la deuxième face du support 110, une forme carrée ou circulaire, voire hexagonale.

Chaque élément métallique 144 présente préférentiellement, selon un plan parallèle à la deuxième face, au moins une dimension latérale $L_{em}$, telle que, pour des éléments métalliques 144 présentant une projection sur la deuxième face du support carré, une longueur d'un côté, pour des éléments métalliques 144 présentant une projection sur la deuxième face du support circulaire, un diamètre, qui est préférentiellement inférieur ou égal à une valeur Lm respectant l'équation suivante :

$$(1) \qquad Lm = \frac{\lambda_0}{2\, n_d \sqrt{(1+\frac{2\delta_{m2}}{h_d})}}$$

avec $\lambda_0$ une longueur d'onde centrale de la plage de longueurs d'onde, $n_d$ un indice de réfraction du matériau transparent à ladite longueur d'onde centrale, $h_d$ l'épaisseur de la couche transparente et $\delta_{m2}$ l'épaisseur de peau du deuxième métal à ladite longueur d'onde centrale.

On notera que d'une manière particulièrement avantageuse, les éléments métalliques 144 présentent, selon le plan sensiblement parallèle à la deuxième face, une dimension latérale maximale et une dimension latérale minimale toutes deux comprises entre 0,75 fois la valeur Lm et 1,25 fois la valeur Lm.

Selon une première possibilité de l'invention, les éléments métalliques peuvent présenter un agencement non périodique avec un espacement entre deux éléments métalliques adjacents présentant préférentiellement un pas P inférieur ou égal à $\lambda_0/n_d$, $\lambda_0$ étant une longueur d'onde centrale de la plage de longueurs d'onde et $n_d$ l'indice de réfraction du matériau transparent dans la plage de longueurs d'onde. D'une manière particulièrement avantageuse, le pas P entre deux éléments métalliques 144 adjacents dans l'ensemble d'éléments métalliques 144 est inférieur à 0,75 fois $\lambda_0/n_d$.

Selon une deuxième possibilité de l'invention, les éléments métalliques 144 peuvent présenter un agencement périodique avec un pas de réseau P inférieur ou égal à $\lambda_0/n_d$, le pas de réseau étant préférentiellement inférieur à 0,75 fois $\lambda_0/n_d$.On notera que selon cette deuxième possibilité, les éléments métalliques peuvent être agencés selon un réseau carré avec le pas de réseau P.

On notera que, dans le cas d'un deuxième métal non noble, tel que le titane Ti, afin de limiter les risques d'oxydation, il est envisageable, selon une possibilité non illustrée, de prévoir le dépôt d'une couche de passivation de quelques nanomètres sur les éléments métalliques 144. Ainsi, par exemple et pour un deuxième métal en titane Ti, il est envisageable que les éléments métalliques 144 soient recouverts par une couche de passivation en nitrure de silicium SiN ou de sulfure de zinc ZnS d'une épaisseur comprise entre 5 et 30 nm. Une telle couche de passivation peut ainsi par exemple présenter une épaisseur de 10 nm.

De plus, dans le cadre du choix des premier et deuxième métaux, et du matériau transparent pour des applications d'un composant de détection 1 refroidi à relativement basse température, c'est-à-dire typiquement inférieure à -100°C ou 173 K, ces matériaux pourront être choisis avec des coefficients de dilatation thermique voisins. Selon cette possibilité, le premier métal peut être le platine Pt, le deuxième métal le titane Ti et le matériau transparent peut être un dioxyde de silicium amorphe a-$SiO_2$, ces matériaux présentant un coefficient de dilatation thermique de l'ordre de $9.10^{-6}$ $K^{-1}$.

En variante à ce présent mode de réalisation, les éléments métalliques peuvent être réalisés dans un troisième métal. Selon cette variante, le troisième métal est choisi de telle manière à ce que, comme le deuxième métal, il présente un coefficient d'extinction $k_{m3}$ inférieur ou égal à $2n_{m3}$, $n_{m3}$ étant l'indice de réfraction du troisième métal dans la plage de longueur d'onde. Ainsi, dans le cadre d'une application de l'invention au proche infrarouge et au moyen infrarouge, le troisième métal peut être du titane Ti ou en du latine Pt, ou encore du tungstène W, voire un alliage de titane et de platine.

Ainsi, dans un exemple pratique de ce premier mode de réalisation, pour une plage de longueurs d'onde centrée autour d'une longueur d'onde centrale $\lambda_0$ de 2,7 $\mu$m, le masque opaque 140 peut présenter les caractéristiques suivantes :

- une première couche métallique 141 réalisée en titane Ti avec une épaisseur $h_{m1}$ de 150 nm,
- une deuxième couche métallique 142 réalisée en or Au avec une épaisseur $h_{m2}$ de 100 nm,
- une troisième couche transparente 143 réalisée en dioxyde de silicium $SiO_2$ avec une épaisseur $h_d$ de 120 nm,
- un ensemble d'éléments métalliques 144 dans lequel les éléments métalliques présentent une projection sur la deuxième face du support de forme carrée avec une longueur $L_{em}$ de côté de 450 nm, et une épaisseur $h_{em}$ de 200 nm, les éléments métalliques étant arrangés selon un réseau carré avec un pas P de 800 nm.

Les simulations d'un tel masque opaque 140 effectuées par les inventeurs suivant la méthode modale par développement de Fourier, d'ondes couplée plus connue sous le sigle anglais RCWA pour Rigorous Coupled-Waves Analysis, permettent de montrer qu'un tel masque présente, comme le montre la figure 3A, une transmittance sur une plage de longueurs d'onde allant au moins 1.5$\mu$mà 5$\mu$m Inférieure à $5.10^{-6}$ et une réflectivité inférieure à 2% sur une plage de longueur allant de 2,45 $\mu$m à 3,1 $\mu$m avec un minimum à 0,03% pour la longueur centrale de 2,7 $\mu$m.

Afin de démontrer la faible variation de la réflectivité R d'un tel masque opaque 140 avec l'angle d'incidence du rayonnement électromagnétique $\lambda$, la figure 3A illustre graphiquement la variation de la réflectivité d'un tel masque opaque 140 en fonction de la longueur d'onde du rayonnement électromagnétique obtenue pour, sous la référence 201, un rayonnement électromagnétique arrivant sur la deuxième face avec une incidence normale, sous la référence 202, un rayonnement électromagnétique arrivant sur la deuxième face avec une incidence à 30° de la normale et une polarisation transverse électrique, c'est-à-dire avec un champ électrique parallèle à la deuxième face du support, et sous la référence 203, un rayonnement électromagnétique arrivant sur la deuxième face avec une incidence à 30° de la normale et une polarisation transverse magnétique.

On peut ainsi voir que dans la plage de longueurs d'onde allant de 2,45 μm à 3,1 μm et peu importe la polarisation et l'incidence du rayonnement électromagnétique, la réflectivité reste inférieure à 0,02.

De plus, il est possible d'optimiser le masque opaque 140 afin d'obtenir une plage de longueurs d'onde plus importante pour laquelle la réflectivité reste inférieure à 5%. Ainsi, si l'on prend le masque opaque 140 selon l'exemple précédent et pour lequel les éléments métalliques 144 présentent une dimension latérale $L_{em}$ égale à 500 nm, une épaisseur $h_{em}$ égal à 225 nm et un pas P de réseau de 1,1 μm, et la couche transparente 143 présente une épaisseur $h_d$ de 140 nm, il est possible d'obtenir, conformément aux simulations des inventeurs, une variation de réflectivité 211 telle qu'illustrée sur la figure 3B. Avec une telle configuration, la réflectivité sur une plage de longueurs d'onde allant de 1,1 μm à 3,3 μm reste inférieure à 6, 5%.

Selon l'invention et afin d'éviter toutes fuites optiques sur la structure masquée 122 qui pourrait avoir pour origine des phénomènes de diffraction liés aux bords du masque opaque 140, il est possible d'agencer le masque opaque 140 sur la deuxième face du support 110 pour occulter le rayonnement électromagnétique λ pour l'au moins une structure masquée 122 et certaines structures de détection 123 adjacentes à ladite au moins une structure masquée 122. Une telle possibilité permet également de limiter les phénomènes de courants de fuites qui peuvent exister dans un tel composant de détection 1 entre les structures de détection et qui pourraient donc parasiter le signal de bruit mesuré par la structure masquée.

Afin d'illustrer ce phénomène, comme le montre la figure 4, les inventeurs ont calculé le signal d'absorption A pour, sous la référence 221, une structure masquée 122 dont les structures directement adjacentes 123 sont également couvertes par le masque opaque 140 selon l'exemple pratique, et sous la référence 222, une structure masquée 122 dont les structures directement adjacentes et celles qui leurs sont adjacentes sont également couvertes par le masque opaque 140 selon l'exemple pratique, ceci en fonction d'une épaisseur du support 110 divisée par son indice de réfraction. Ce signal d'absorption A inclut à la fois le signal d'absorption de la structure masquée lié aux phénomènes de diffraction et aux courants de fuite entre les structures de détection 122, 123. Dans cette configuration simulée par les inventeurs, il a été considéré un agencement des structures en matrice avec un pas de réseau de 15 μm.

On peut ainsi voire que, pour un support 110 en tellurure de cadmium et de zinc CdZnTe de 10 μm d'épaisseur, c'est-à-dire un rapport épaisseur du support sur indice de réfraction de 7,5, il nécessaire que les structures directement adjacentes et celles qui leurs sont adjacentes soient également couvertes par le masque opaque 140 pour obtenir une absorption inférieure à 0,1%.

Ainsi, conformément aux calculs réalisés par les inventeurs, il est donc possible, pour un composant de détection 1 comprenant un support de 10 μm d'épaisseur et avec un masque opaque 140 qui s'étend, de part et d'autre d'une projection de la structure masquée 122 sur la deuxième face, sur une distance supérieure à 30 μm (c'est-à-dire 2 pixels adjacents de 15 μm de côté), pour une distance supérieure à 15 μm cette absorption reste inférieure à 0,1%. Avec cette même épaisseur de support, pour une telle distance supérieure à 15 μm (c'est-à-dire 1 seul pixel adjacent de 15 μm de côté), cette absorption reste inférieure à 0,15%.

Les figures 5A et 5B illustrent deux exemples de mise en œuvre d'un tel masque opaque 140 dans le cadre d'un composant de détection comportant une matrice de structures de détection 121, 122, 124. Ces figures illustrent le positionnement du ou des masques opaques vis-à-vis de la projection de la matrice des structures de détection sur la deuxième face du support 110.

Selon le premier exemple illustré sur la figure 5A, il est envisageable d'utiliser un masque opaque 140 agencé pour occulter le rayonnement électromagnétique pour des structures masquées 122 individuelles. Selon cette possibilité, le composant de détection comporte une pluralité de masques opaques 140 correspondant chacun à une structure masquée 122 respective et les structures adjacentes 123 correspondantes.

Selon le deuxième exemple préféré et illustré sur la figure 5B, le composant de détection 1 peut comporter un unique masque opaque 140 agencé pour occulter le rayonnement électromagnétique pour une pluralité de structures masquées 122 disposées sur un bord de la matrice des structures de détection. Ainsi, selon cet exemple, le masque opaque est agencé en regard d'une colonne de cinq structures de détection 122, 123 s'étendant le long dudit bord, la troisième structure de détection 122 de ladite colonne correspondant à la structure masquée. Ainsi, selon cette possibilité, le composant de détection présente une ligne de structures masquées permettant de fournir un niveau de bruit moyen précis puisque calculé sur un nombre important de structures masquées 122.

Un composant de détection 1 selon ce premier mode de réalisation peut être fabriqué à partir d'un procédé comprenant les étapes suivantes :

- fourniture d'un support 110 comprenant une couche 120, dite couche active, dans laquelle est aménagée une pluralité de structures de détection 121a, 121b, 122, 123 de rayonnement électromagnétique λ dans ladite plage de longueurs d'onde, le support 110 comprenant une première face à partir de laquelle s'étend la couche active 120, et une deuxième face,

opposée à la première face par laquelle le support 110 est destinée à recevoir le rayonnement électromagnétique λ,

- dépôt de la première couche métallique 141 réalisée dans le premier métal en contact de la deuxième face du support 110,
- dépôt de la deuxième couche métallique 142 réalisée dans le deuxième métal en contact avec la première couche métallique 141,
- dépôt de la couche transparente143, réalisée dans le matériau transparent en contact avec la deuxième couche métallique 142, la troisième couche 143 étant dite couche transparente,
- formation d'un ensemble d'éléments métalliques 144 réalisés dans le deuxième métal sur la couche transparente 143 à l'opposé de la deuxième couche métallique 142.

On notera que l'étape de formation de l'ensemble d'éléments métalliques 144 peut comporter une sous-étape de dépôt d'une quatrième couche du deuxième métal d'une épaisseur $h_{em}$ et une sous-étape de gravure localisée, par exemple au travers d'une lithographie optique, pour ne garder que les parties de la quatrième couche correspondant aux éléments métalliques 144.

Selon une première et une deuxième variante de ce mode de réalisation principal de l'invention illustrées respectivement sur les figures 6A et 6B, le masque opaque 140 peut comprendre en outre et pour chacun des éléments métalliques 144, une portion de quatrième couche 145, dite quatrième couche transparente, réalisée dans le matériau transparent, et une portion de cinquième couche métallique 146 réalisée dans le deuxième métal de telle manière à former une deuxième structure MIM 152 dans la plage de longueurs d'onde.

Dans un tel agencement, avec l'élément métallique 144 faisant à la fois partie de la première structure MIM 151, en conformité avec l'enseignement du présent document et avec le mode de réalisation principal, et de la deuxième structure MIM 152, conformément à ces première et deuxième variantes, on obtient une superposition des cavités résonantes de ces première et deuxième structures MIM 151, 152. Les cavités correspondant aux deuxièmes structures MIM 152 présentent des dimensions latérales inférieures ou égales à celles correspondant aux premières structures MIM 151 puisque les dimensions latérales des cavités des deuxièmes structures MIM 152 correspondent à celles des portions de quatrième couche transparente 145.

Comme cela est discuté ci-après en relation avec la figure 7, une telle configuration avec des dimensions distinctes des cavités correspondant aux premières et deuxièmes structures MIM 151, 152 permet un élargissement de la plage de longueur d'onde d'opacité du masque opaque 140 selon ces première et deuxième variantes vis-à-vis du mode de réalisation principal. On notera que ces première et deuxième variantes sont particulièrement avantageuses dans le cadre d'une plage de longueurs d'onde dans les infrarouges lointains, par exemple comprise entre 8 et 14 μm, puisqu'elles permettent d'obtenir une plage d'opacité relativement large sans nécessiter un indice de réfraction relativement faible, c'est-à-dire inférieur à 2, pour le matériau transparent, de tels matériaux transparents n'étant pas aisés à fournir pour ces plages de longueurs d'onde.

Ainsi, si l'on prend la première variante de ce premier mode de réalisation illustrée sur la figure 6A, un composant de détection 1 selon cette première variante se différencie d'un composant de détection selon le mode de réalisation principal, en ce que le masque opaque 140 comprend, pour chaque élément métallique 144 et à partir de la troisième couche transparente , un deuxième empilement successif :

- dudit élément métallique 144,
- d'une portion de quatrième couche 145, dite quatrième couche transparente, réalisée dans le matériau transparent,
- d'une portion de cinquième couche métallique 146 réalisée dans le deuxième métal.

On notera, de plus que, dans cette première variante, la portion de quatrième couche transparente 145 et la portion de cinquième couche métallique 145 prolonge l'élément métallique 144 correspondant et présentent, de ce fait, des dimensions latérales identiques à celles dudit élément métallique 144. L'épaisseur respective de la quatrième couche transparente 145 et de la cinquième couche métallique peuvent être déterminée de manière similaire à l'épaisseur de respectivement la troisième couche transparente 143 et celle des éléments métalliques 144 et peuvent être ajustées afin d'optimiser la plage de longueur d'onde. Ainsi, si selon une possibilité de cette première variante, la quatrième couche transparente 145 peut avoir une épaisseur identique celle de la troisième couche transparente 143, il est également parfaitement envisageable que la quatrième couche transparente 145 présente une épaisseur plus importante que celle de la troisième couche transparente 143, celle-ci restant, préférentiellement supérieure ou égale à $\lambda_0/50n_d$, voire à $\lambda_0/25n_d$.

Ainsi, selon un exemple de réalisation de cette première variante, le masque opaque 140 peut présenter les caractéristiques suivantes :

- une première couche métallique 141 en or Au de 100 nm d'épaisseur,
- une deuxième couche métallique 142 en titane Ti de 150 nm d'épaisseur,
- une troisième couche transparente 143 en sulfure de zinc ZnS de 100 nm d'épaisseur,
- des éléments métalliques 144 en titane Ti de 600 nm d'épaisseur,
- une quatrième couche transparente 145 en sulfure de zinc ZnS de 200 nm d'épaisseur,
- une cinquième couche métallique 146 en titane Ti

de 600 nm d'épaisseur, et

- une dimension latérale pour les éléments métallique 144, les portions de quatrième couche transparente 145 et cinquième couche métallique 146.

La figure 7 permet de comparer la variation, avec la longueur d'onde, de la réflectivité d'un tel masque opaque 140 vis-à-vis d'un masque opaque selon le mode de réalisation principal présentant la même configuration, la quatrième couche transparente 145 et la cinquième couche métallique 146 étant omises.

On peut voir sur ce graphique qu'une telle première variante permet d'obtention d'une plage de longueur d'onde relativement étendue, puisqu'elle s'étend d'environ 9,5 $\mu$m à environ 13 $\mu$m, vis-à-vis de celle qui est obtenue pour un masque opaque 140 selon le mode de réalisation principal qui s'étend d'environ 10,2 $\mu$m à environ 10,8 $\mu$m.

Un composant de détection 1 selon cette première variante du mode de réalisation principal peut être fabriqué à partir d'un procédé de fabrication qui se différencie d'un procédé de fabrication d'un composant de détection 1 selon le premier mode de réalisation principal en ce que, lors de la formation de l'ensemble d'éléments métalliques 144, il est prévu une étape de formation de la quatrième couche transparente 145 et de la cinquième couche métallique 146 sur une couche métallique réalisée dans le troisième métal destinée à la formation des éléments métalliques 144, et une étape de gravure localisée de la cinquième couche métallique 146, de la quatrième couche transparente 145 et de la couche métallique réalisée dans le troisième métal afin de délimiter latéralement les éléments métalliques, les portions de la quatrièmes couche transparente 145 et les portions de la cinquième couche transparente 146.

Selon la deuxième variante du mode de réalisation principal de l'invention, illustrée sur la figure 6B, les portions de quatrième couche transparente 145 et de cinquième couche métallique 146 peuvent présenter des dimensions latérales inférieures à celle des éléments métalliques correspondants.

Ainsi, un composant de détection 1 selon cette deuxième variante du premier mode de réalisation se différencie d'un composant de détection 1 selon la première variante du premier mode de réalisation en ce que, pour chaque élément métallique 144, la portion de quatrième couche transparente 145 correspondante et la portion de cinquième couche métallique 146 correspondante présentent des dimensions latérales inférieures à celle dudit élément métallique 144.

Le procédé de fabrication d'un composant de détection 1 selon cette deuxième variante du premier mode de réalisation se différencie du procédé de fabrication d'un composant de détection 1 selon la première variante du premier mode de réalisation en ce que l'étape de gravure localisée de la cinquième couche métallique 146, de la quatrième couche transparente 145 et de la couche métallique réalisée dans le troisième métal est réalisée en deux fois, l'une permettant une gravure localisée de la quatrième couche transparente 145 et de la cinquième couche métallique, et l'autre permettant une gravure localisée de la couche du troisième métal. Une telle gravure localisée en deux fois permet de fournir, pour chaque élément métallique 144, une portion de quatrième couche transparente 145 et une portion de cinquième couche métallique 146 avec des dimensions inférieures à celles de la quatrième couche transparente.

On notera que si dans le premier mode de réalisation de l'invention et dans les première et deuxième variantes du premier mode de réalisation, la deuxième couche métallique 142 et les éléments métalliques 144 sont réalisés dans le deuxième métal, il est néanmoins envisageable, sans que l'on sorte du cadre de l'invention, que le masque opaque 140 comporte un troisième métal et que les éléments métalliques soient réalisés dans le troisième métal. Un tel troisième métal présente alors un coefficient d'extinction $k_{m3}$ strictement inférieur à $5n_{m3}$, voire inférieur ou égal à $2n_{m3}$ avec $n_{m3}$ l'indice de réfraction du troisième métal dans la plage de longueurs d'onde.De la même façon, si dans les première et deuxième variantes du mode de réalisation principal, la quatrième couche transparente 145 est réalisée dans le matériau transparent, il est également envisageable, sans que l'on sorte de l'invention, que la quatrième couche transparente 145 soit réalisée dans un deuxième matériau transparent, étant entendu que le deuxième matériau présentant un indice de réfraction inférieur ou égal à 2 dans la plage de longueurs d'onde. De même, si dans les première et deuxième variantes du mode de réalisation principal, la cinquième couche métallique 146 est réalisée dans le deuxième métal, il est également envisageable, sans que l'on sorte du cadre de l'invention, que la cinquième couche métallique 146 soit réalisée dans un quatrième métal. Un tel quatrième métal présente alors préférentiellement un coefficient d'extinction $k_{m4}$ strictement inférieur à $5n_{m4}$, voire inférieur ou égal à $2n_{m4}$ avec $n_{m4}$ l'indice de réfraction du quatrième métal dans la plage de longueurs d'onde.

**Revendications**

1. Composant de détection (1) de rayonnement électromagnétique ($\lambda$) dans une plage de longueurs d'onde comprenant :

   - un support (110) comprenant une couche (120), dite couche active, dans laquelle est aménagée une pluralité de structures de détection (121a, 121b, 122, 123) de rayonnement électromagnétique ($\lambda$) dans ladite plage de longueurs d'onde, le support (110) comprenant une première face à partir de laquelle s'étend la couche active (120), et une deuxième face, opposée à la première face, par laquelle le support (110) est destinée à recevoir le rayonnement électromagnétique (À),

- au moins un masque (140), dit masque opaque, agencé sur une portion de la deuxième face du support (110) pour occulter le rayonnement électromagnétique pour au moins une des structures de détection (122), dite structure masquée, le composant de détection (1) **étant caractérisé en ce que** le masque opaque (140) comprend au moins un premier, un deuxième et un troisième métal et un matériau, dit matériau transparent, d'indice de réfraction inférieur ou égal à 2 dans la plage de longueurs d'onde, le premier métal présentant un coefficient d'extinction $k_{m1}$ supérieur ou égal $5n_{m1}$, voire à $10n_{m1}$, et le deuxième et le troisième métal présentant chacun un coefficient d'extinction $k_{m2/3}$ strictement inférieur à $5n_{m2/3}$, voire inférieur ou égal à $2n_{m2/3}$ avec $n_{m1}$ et $n_{m2/3}$ les indices de réfraction respectifs du premier et de chacun desdits deuxième et troisième métaux dans la plage de longueurs d'onde, le matériau transparent présentant un coefficient d'extinction $k_t$ inférieur ou égal à 0,01, dans lequel le masque opaque (140) comprend, à partir de la deuxième face du support (110), un empilement successif:
- d'une première couche métallique (141) réalisée dans le premier métal,
- d'une deuxième couche métallique (142) réalisée dans le deuxième métal,
- d'une troisième couche (143), dite couche transparente, réalisée dans le matériau transparent, et
- d'un ensemble d'éléments métalliques (144) réalisés dans le troisième métal, ledit ensemble étant agencé sur la couche transparente (143) à l'opposé de la deuxième couche métallique (142),

et dans lequel la deuxième couche métallique (142), la couche transparente (143) et l'ensemble d'éléments métalliques (144) forment des structures MIM dans la plage de longueurs d'onde.

**2.** Composant de détection (1) selon la revendication 1, dans lequel le deuxième et le troisième métal sont identiques.

**3.** Composant de détection (1) selon la revendication 1 ou 2, dans lequel la première couche métallique (141) présente une épaisseur $h_{m1}$ supérieure à 2 fois une épaisseur de peau $\delta_{m1}$ du premier métal dans la plage de longueurs d'onde, l'épaisseur de la première couche métallique (141) étant préférentiellement supérieure à 4 fois l'épaisseur de peau $\delta_{m1}$ du premier métal dans la plage de longueurs d'onde.

**4.** Composant de détection (1) selon l'une quelconque des revendications 1 à 3, dans lequel la deuxième couche métallique (142) présente une épaisseur $h_{m2}$ comprise entre 0,5 fois une épaisseur de peau $\delta_{m2}$ du deuxième métal dans la plage de longueurs d'onde et à 4 fois l'épaisseur de peau $\delta_{m2}$ du deuxième métal dans la plage de longueurs d'onde, l'épaisseur de la première couche métallique (141) étant préférentiellement supérieure à 4 fois l'épaisseur de peau $\delta_{m1}$ du premier métal dans la plage de longueurs d'onde.

**5.** Composant de détection (1) selon la revendication 2 seule ou en combinaison avec la revendication 3 ou 4, dans lequel les éléments métalliques (144) présentent, selon un plan sensiblement parallèle à la deuxième face, au moins une dimension latérale L inférieure ou égale à une valeur Lm respectant l'équation suivante :

$$Lm = \frac{\lambda_0}{2\, n_d \sqrt{(1+\frac{2\delta_{m2}}{h_d})}}$$

avec $\lambda_0$ une longueur d'onde centrale de la plage de longueurs d'onde, $n_d$ un indice de réfraction du matériau transparent à ladite longueur d'onde, $h_d$ une épaisseur de la couche transparente et $\delta_{m2}$ une épaisseur de peau du deuxième métal à ladite longueur d'onde,

les éléments métalliques (144) présentant préférentiellement une dimension latérale maximale et une dimension latérale minimale, selon un plan sensiblement parallèle à la deuxième face, comprises entre 0,75 fois ladite valeur Lm et 1,25 fois la valeur Lm.

**6.** Composant de détection (1) selon l'une quelconque des revendications 1 à 5, dans lequel dans l'ensemble d'éléments métalliques (144), deux éléments métalliques (144) adjacents présentent entre eux une distance inter-barycentre inférieure ou égal à $\lambda_0/n_d$, $\lambda_0$ étant une longueur d'onde centrale de la plage de longueurs d'onde et $n_d$ l'indice de réfraction du matériau transparent dans la plage de longueurs d'onde, le pas P entre deux éléments métalliques (144) adjacents dans l'ensemble d'éléments métalliques (144) étant préférentiellement inférieur à 0,75 fois $\lambda_0/n_d$.

**7.** Composant de détection (1) selon la revendication 6, dans lequel les éléments métalliques (144) de l'ensemble d'éléments métalliques (144) sont agencés périodiquement avec un pas P entre les éléments métalliques (144) inférieur à $\lambda_0/n_d$, ledit pas P entre les entre les éléments métalliques (144) étant préférentiellement inférieur à 0,75 fois $\lambda_0/n_d$.

**8.** Composant de détection (1) selon l'une quelconque des revendications 1 à 6, dans lequel la couche transparente (143) présente une épaisseur comprise entre $\lambda_0/4n_d$ et $\lambda_0/50n_d$, les valeurs $\lambda_0/4n_d$ et $\lambda_0/50n_d$ étant incluses, $\lambda_0$ étant une longueur d'onde centrale de la plage de longueurs d'onde et $n_d$ l'indice de réfraction du matériau transparent (143) dans la plage de longueurs d'onde.

**9.** Composant de détection (1) selon la revendication 2 prise seule ou combinaison avec l'une quelconque des revendications 3 à 8, dans lequel chaque élément métallique (144) de l'ensemble de d'éléments métalliques (144) présente une épaisseur, dans le sens d'empilement du masque opaque (140), qui est comprise entre une fois une épaisseur de peau $\delta_{m2}$ du troisième métal dans la plage de longueurs d'onde et trois fois ladite épaisseur de peau $\delta_{m2}$ du deuxième métal, l'épaisseur de chaque élément métallique étant préférentiellement comprise entre une fois et demie l'épaisseur de peau $\delta_{m2}$ du troisième métal dans la plage de longueurs d'onde et deux fois et demie ladite épaisseur de peau $\delta_{m2}$ du troisième métal.

**10.** Composant de détection (1) selon l'une quelconque des revendications 1 à 9, dans lequel le masque opaque (140) est agencé sur la deuxième face du support (110) pour occulter le rayonnement électromagnétique ($\lambda$) pour l'au moins une structure masquée (122) et les structures de détection (123) adjacentes à ladite au moins une structure masquée (122), le masque étant préférentiellement agencé pour également occulter le rayonnement électromagnétique ($\lambda$) les structures de détection (123) adjacentes auxdites structures de détection (123) adjacentes à ladite au moins une structure masquée (122),
dans lequel le support (110) présente préférentiellement une épaisseur inférieure à 10 $\mu$m avec le masque opaque (140) s'étendant, de part est d'autre d'une projection de la structure masquée (122) sur la deuxième face du support (110) sur une distance supérieure à 15 $\mu$m, voire supérieure à 30 $\mu$m.

**11.** Composant de détection (1) selon l'une quelconque des revendications 1 à 10, dans lequel le masque opaque comprend en outre un quatrième métal, identique ou différent du troisième métal, et un deuxième matériau, dit deuxième matériau transparent, ledit deuxième matériau transparent présentant un indice de réfraction inférieur ou égal à 2 dans la plage de longueurs d'onde,
dans lequel, pour chaque élément métallique, il est prévu, à partir de la troisième couche transparente, un deuxième empilement successif:

- dudit élément métallique (144),
- une portion de quatrième couche (145), dite quatrième couche transparente, réalisée dans le deuxième matériau transparent,
- une portion de cinquième couche métallique (146) réalisée dans le quatrième métal, dans lequel, pour chaque élément métallique (144), la portion de quatrième couche transparente (145) et la portion de cinquième couche métallique (146) forment une deuxième structure MIM dans la plage de longueurs d'onde.

**12.** Procédé de fabrication d'un composant de détection (1) de rayonnement électromagnétique ($\lambda$) dans une plage de longueurs comprenant les étapes suivantes :

- fourniture d'un support (110) comprenant une couche (120), dite couche active, dans laquelle est aménagée une pluralité de structures de détection (121a, 121b, 122, 123) de rayonnement électromagnétique ($\lambda$) dans ladite plage de longueurs d'onde, le support (110) comprenant une première face à partir de laquelle s'étend la couche active (120), et une deuxième face, opposée à la première face par laquelle le support (110) est destinée à recevoir le rayonnement électromagnétique($\lambda$),
- formation d'un masque opaque (140) comprenant, à partir de la deuxième face du support (110), un empilement successif:

o d'une première couche métallique (141) réalisée dans un premier métal,
o d'une deuxième couche métallique (142) réalisée dans un deuxième métal,
o d'une troisième couche (143), dite couche transparente, réalisée dans un matériau dit matériau transparent d'indice de réfraction inférieur ou égal à 2 dans la plage de longueurs d'onde, et
o d'un ensemble d'éléments métalliques (144) réalisés dans un troisième métal, ledit ensemble étant agencé sur la couche transparente (143) à l'opposé de la deuxième couche métallique (142), la deuxième couche métallique (142), la couche transparente (143) et l'ensemble de d'éléments métalliques (144) formant des structures MIM dans la plage de longueurs d'onde,
le masque opaque (140) étant agencé sur une portion de la deuxième face du support (110) pour occulter le rayonnement électromagnétique pour au moins une des structures de détection (122), dite structure masquée,
dans lequel procédé le masque opaque (140) comprend le premier, le deuxième et le troisième métal et le matériau, dit matériau transparent, le premier métal présentant un coefficient d'extinction $k_{m1}$ supérieur ou égal $5n_{m1}$, voire à $10n_{m1}$, et le deuxième et le troisième métal présentant un coefficient d'extinction $k_{m2/3}$ strictement inférieur à 5 $n_{m2/3}$, voire inférieur ou égal à $2n_{m2/3}$ avec $n_{m1}$ et $n_{m2/3}$ les indices de réfraction respectifs du premier et de chacun desdits deuxième et troisième métaux dans la plage de longueurs d'onde, le matériau transparent présentant un coefficient d'extinction $k_t$ inférieur ou égal à 0,01.

**13.** Procédé de fabrication selon la revendication 12, dans lequel l'étape de formation comprend les sous étapes suivantes :

- dépôt de la première couche métallique (141) réalisée dans le premier métal en contact de la deuxième face du support (110),
- dépôt de la deuxième couche métallique (142) réalisée dans le deuxième métal en contact avec la première couche métallique (141),
- dépôt de la couche transparente(143), réalisée dans le matériau transparent en contact avec la deuxième couche métallique (142), la troisième couche (143) étant dite couche transparente,
- formation d'un ensemble d'éléments métalliques (144) réalisés dans le troisième métal sur la couche transparente (143) à l'opposé de la deuxième couche métallique (142).

**14.** Procédé de fabrication selon la revendication 12 ou 13, dans lequel lors de l'étape de formation du masque opaque (140), le masque est agencé sur la deuxième face du support (110) pour occulter le rayonnement électromagnétique (λ) pour l'au moins une structure masquée (122) et les structures de détection (123) adjacentes à ladite au moins une structure masquée (122).

**15.** Procédé de fabrication selon l'une quelconque des revendications 12 à 14, dans lequel il est en outre prévu, pour chaque éléments métalliques (144), la formation d'une portion de quatrième couche (145), dite quatrième couche transparente, réalisée dans un deuxième matériau dit deuxième matériau transparent, et d'une portion de cinquième couche métallique (146) réalisée dans un quatrième métal, différent ou identique au troisième métal, de telle manière à former, pour chaque élément métallique (144) et à partir de la troisième couche transparente (143), un deuxième empilement successif de : l'élément métallique (144), la portion de quatrième couche transparente (145) et la portion de cinquième couche métallique (146),

dans lequel le deuxième matériau transparent présentant un indice de réfraction inférieur ou égal à 2 dans la plage de longueurs d'onde, et dans lequel, pour chaque élément métallique (144), la portion de quatrième couche transparente (145) et la portion de cinquième couche métallique (146) forment une deuxième structure MIM dans la plage de longueurs d'onde.

**Patentansprüche**

**1.** Sensorbauteil (1) für elektromagnetische Strahlung (λ) in einem Wellenlängenbereich, umfassend:

- einen Träger (110), umfassend eine Schicht (120), so genannte aktive Schicht, in der eine Vielzahl von Sensorstrukturen (121a, 121b, 122, 123) für elektromagnetische Strahlung (λ) in dem Wellenlängenbereich eingerichtet ist, wobei der Träger (110) eine erste Seite umfasst, von der ausgehend sich die aktive Schicht (120) erstreckt, und eine zweite Seite, die der ersten Seite gegenüberliegt, durch welche der Träger (110) die elektromagnetische Strahlung (λ) aufnehmen soll,
- wenigstens eine Maske (140), so genannte opake Maske, die auf einem Abschnitt der zweiten Seite des Trägers (110) angeordnet ist, um die elektromagnetische Strahlung für wenigstens eine der Sensorstrukturen (122), so genannte maskierte Struktur, zu verdecken,

wobei das Sensorbauteil (1) **dadurch gekennzeichnet ist, dass** die opake Maske (140) wenigstens ein erstes, ein zweites und ein drittes Metall und ein Material, so genanntes transparentes Material, mit einem Brechungsindex kleiner oder gleich 2 in dem Wellenlängenbereich umfasst, wobei das erste Metall einen Extinktionskoeffizienten $k_{m1}$ größer oder gleich $5n_{m1}$, oder sogar $10n_{m1}$, aufweist, wobei das zweite und das dritte Metall jeweils einen Extinktionskoeffizienten $k_{m2/3}$ strikt kleiner als $5n_{m2/3}$, oder sogar kleiner oder gleich $2n_{m2/3}$ aufweisen, mit $n_{m1}$ und $n_{m2/3}$ als jeweilige Brechungsindizes des ersten und jedes des zweiten und dritten Metalls in dem Wellenlängenbereich, wobei das transparente Material einen Extinktionskoeffizienten $k_t$ kleiner oder gleich 0,01 aufweist,
wobei die opake Maske (140) ausgehend von der zweiten Seite des Trägers (110) eine aufeinanderfolgende Schichtung umfasst:

- einer ersten Metallschicht (141), die in dem ersten Metall ausgeführt ist,
- einer zweiten Metallschicht (142), die in dem

zweiten Metall ausgeführt ist,

- einer dritten Schicht (143), so genannten transparenten Schicht, die in dem transparenten Material ausgeführt ist, und

- einer Einheit von Metallelementen (144), die in dem dritten Metall ausgeführt sind, wobei die Einheit auf der transparenten Schicht (143) gegenüber der zweiten Metallschicht (142) angeordnet ist,

und wobei die zweite Metallschicht (142), die transparente Schicht (143) und die Einheit von Metallelementen (144) MIM-Strukturen in dem Wellenlängenbereich bilden.

**2.** Sensorbauteil (1) nach Anspruch 1, wobei das zweite und das dritte Metall identisch sind.

**3.** Sensorbauteil (1) nach Anspruch 1 oder 2, wobei die erste Metallschicht (141) eine Dicke $h_{m1}$ größer 2 Mal eine Eindringtiefe $\delta_{m1}$ des ersten Metalls in dem Wellenlängenbereich aufweist, wobei die Dicke der ersten Metallschicht (141) vorzugsweise größer 4 Mal die Eindringtiefe $\delta_{m1}$ des ersten Metalls in dem Wellenlängenbereich ist.

**4.** Sensorbauteil (1) nach einem der Ansprüche 1 bis 3, wobei die zweite Metallschicht (142) eine Dicke $h_{m2}$ aufweist, die zwischen 0,5 Mal eine Eindringtiefe $\delta_{m2}$ des zweiten Metalls in dem Wellenlängenbereich und 4 Mal die Eindringtiefe $\delta_{m2}$ des zweiten Metalls in dem Wellenlängenbereich beträgt, wobei die Dicke der ersten Metallschicht (141) vorzugsweise größer 4 Mal die Eindringtiefe $\delta_{m1}$ des ersten Metalls in dem Wellenlängenbereich ist.

**5.** Sensorbauteil (1) nach Anspruch 2 allein oder in Kombination mit Anspruch 3 oder 4, wobei die Metallelemente (144) gemäß einer zu der zweiten Seite im Wesentlichen parallelen Ebene wenigstens eine seitliche Dimension L kleiner oder gleich einem Wert Lm entsprechend der folgenden Gleichung aufweisen:

$$Lm = \frac{\lambda_0}{2\, n_d \sqrt{(1 + \frac{2\delta_{m2}}{h_d})}}$$

wobei $\lambda_0$ eine zentrale Wellenlänge des Wellenlängenbereichs, $n_d$ ein Brechungsindex des transparenten Materials bei der Wellenlänge, $h_d$ eine Dicke der transparenten Schicht und $\delta_{m2}$ eine Eindringtiefe des zweiten Metalls bei der Wellenlänge sind,

wobei die Metallelemente (144) vorzugsweise eine maximale seitliche Dimension und eine minimale seitliche Dimension gemäß einer zu der zweiten Seite im Wesentlichen parallelen Ebene aufweisen, die zwischen 0,75 Mal dem Wert Lm und 1,25 Mal dem Wert Lm betragen.

**6.** Sensorbauteil (1) nach einem der Ansprüche 1 bis 5, wobei in der Einheit von Metallelementen (144) zwei nebeneinanderliegende Metallelemente (144) zwischen sich eine inter-baryzentrische Distanz kleiner oder gleich $\lambda_0/n_d$ aufweisen, wobei $\lambda_0$ eine zentrale Wellenlänge des Wellenlängenbereichs und $n_d$ der Brechungsindex des transparenten Materials in dem Wellenlängenbereich sind, wobei die Teilung P zwischen zwei nebeneinanderliegenden Metallelementen (144) in der Einheit von Metallelementen (144) vorzugsweise kleiner als 0,75 Mal $\lambda_0/n_d$ ist.

**7.** Sensorbauteil (1) nach Anspruch 6, wobei die Metallelemente (144) der Einheit von Metallelementen (144) periodisch mit einer Teilung P zwischen den Metallelementen (144) kleiner als $\lambda_0/n_d$ angeordnet sind, wobei die Teilung P zwischen den Metallelementen (144) vorzugsweise kleiner als 0,75 Mal $\lambda_0/n_d$ ist.

**8.** Sensorbauteil (1) nach einem der Ansprüche 1 bis 6, wobei die transparente Schicht (143) eine Dicke aufweist, die zwischen $\lambda_0/4n_d$ und $\lambda_0/50n_d$ beträgt, wobei die Werte $\lambda_0/4n_d$ und $\lambda_0/50n_d$ inkludiert sind, wobei $\lambda_0$ eine zentrale Wellenlänge des Wellenlängenbereichs und $n_d$ der Brechungsindex des transparenten Materials (143) in dem Wellenlängenbereich sind.

**9.** Sensorbauteil (1) nach Anspruch 2 allein oder in Kombination mit irgendeinem der Ansprüche 3 bis 8, wobei jedes Metallelement (144) der Einheit von Metallelementen (144) eine Dicke in der Schichtungsrichtung der opaken Maske (140) aufweist, die zwischen einem Mal eine Eindringtiefe $\delta_{m2}$ des dritten Metalls in dem Wellenlängenbereich und drei Mal die Eindringtiefe $\delta_{m2}$ des zweiten Metalls beträgt, wobei die Dicke jedes Metallelements vorzugsweise zwischen eineinhalb Mal die Eindringtiefe $\delta_{m2}$ des dritten Metalls in dem Wellenlängenbereich und zweieinhalb Mal die Eindringtiefe $\delta_{m2}$ des dritten Metalls beträgt.

**10.** Sensorbauteil (1) nach einem der Ansprüche 1 bis 9, wobei die opake Maske (140) auf der zweiten Seite des Trägers (110) angeordnet ist, um die elektromagnetische Strahlung ($\lambda$) für die wenigstens eine maskierte Struktur (122) und die an die wenigstens eine maskierte Struktur (122) angrenzenden Sensorstrukturen (123) zu verdecken, wobei die Maske vorzugsweise angeordnet ist, um die elektromagnetische Strahlung ($\lambda$) ebenfalls für die Sensorstrukturen (123) zu verdecken, die an die an die wenigstens eine maskierte Struktur (122) angrenzenden Sensorstrukturen (123) angrenzen,

wobei der Träger (110) vorzugsweise eine Dicke

kleiner als 10 μm aufweist, wobei sich die opake Maske (140) auf jeder Seite einer Projektion der maskierten Struktur (122) auf der zweiten Seite des Trägers (110) über eine Distanz größer als 15 μm, sogar größer als 30 μm erstreckt.

**11.** Sensorbauteil (1) nach einem der Ansprüche 1 bis 10, wobei die opake Maske weiter ein viertes Metall, das mit dem dritten Metall identisch oder davon verschieden ist, und ein zweites Material, so genanntes transparentes zweites Material, umfasst, wobei das transparente zweite Material einen Brechungsindex kleiner oder gleich 2 in dem Wellenlängenbereich aufweist,

wobei für jedes Metallelement ausgehend von der transparenten dritten Schicht eine zweite aufeinanderfolgende Schichtung vorgesehen ist:

- des Metallelements (144),
- eines Abschnitts einer vierten Schicht (145), so genannten transparenten vierten Schicht, die in dem transparenten zweiten Material ausgeführt ist,
- eines Abschnitts einer fünften Metallschicht (146), die in dem vierten Metall ausgeführt ist,

wobei für jedes Metallelement (144) der Abschnitt der transparenten vierten Schicht (145) und der Abschnitt der fünften Metallschicht (146) eine zweite MIM-Struktur in dem Wellenlängenbereich bilden.

**12.** Verfahren zur Herstellung eines Sensorbauteils (1) für elektromagnetische Strahlung (λ) in einem Wellenlängenbereich, umfassend folgende Schritte:

- Bereitstellen eines Trägers (110), umfassend eine Schicht (120), so genannte aktive Schicht, in der eine Vielzahl von Sensorstrukturen (121a, 121b, 122, 123) für elektromagnetische Strahlung (λ) in dem Wellenlängenbereich eingerichtet ist, wobei der Träger (110) eine erste Seite umfasst, von der ausgehend sich die aktive Schicht (120) erstreckt, und eine zweite Seite, die der ersten Seite gegenüberliegt, durch welche der Träger (110) die elektromagnetische Strahlung (λ) aufnehmen soll,
- Bilden einer opaken Maske (140), die ausgehend von der zweiten Seite des Trägers (110) eine aufeinanderfolgende Schichtung umfasst:

o einer ersten Metallschicht (141), die in dem ersten Metall ausgeführt ist,
o einer zweiten Metallschicht (142), die in dem zweiten Metall ausgeführt ist,
o einer dritten Schicht (143), so genannten transparenten Schicht, die in einem Material, so genannten transparenten Material, mit einem Brechungsindex kleiner oder gleich 2 in dem Wellenlängenbereich ausgeführt ist, und
o einer Einheit von Metallelementen (144), die in einem dritten Metall ausgeführt sind, wobei die Einheit auf der transparenten Schicht (143) gegenüber der zweiten Metallschicht (142) angeordnet ist, wobei die zweite Metallschicht (142), die transparente Schicht (143) und die Einheit von Metallelementen (144) MIM-Strukturen in dem Wellenlängenbereich bilden,

wobei die opake Maske (140) auf einem Abschnitt der zweiten Seite des Trägers (110) angeordnet ist, um die elektromagnetische Strahlung für wenigstens eine der Sensorstrukturen (122), so genannte maskierte Struktur, zu verdecken,
wobei in dem Verfahren die opake Maske (140) das erste, das zweite und das dritte Metall und das Material, so genannte transparente Material, umfasst, wobei das erste Metall einen Extinktionskoeffizienten $k_{m1}$ größer oder gleich $5n_{m1}$, oder sogar $10n_{m1}$, aufweist, und das zweite und das dritte Metall einen Extinktionskoeffizienten $k_{m2/3}$ strikt kleiner als $5n_{m2/3}$, oder sogar kleiner oder gleich $2n_{m2/3}$ aufweisen, mit $n_{m1}$ und $n_{m2/3}$ als jeweilige Brechungsindizes des ersten und jedes des zweiten und dritten Metalls in dem Wellenlängenbereich, wobei das transparente Material einen Extinktionskoeffizienten $k_t$ kleiner oder gleich 0,01 aufweist.

**13.** Herstellungsverfahren nach Anspruch 12, wobei der Schritt des Bildens folgende Teilschritte umfasst:

- Aufbringen der ersten Metallschicht (141), die in dem ersten Metall ausgeführt ist, in Kontakt mit der zweiten Seite des Trägers (110),
- Aufbringen der zweiten Metallschicht (142), die in dem zweiten Metall ausgeführt ist, in Kontakt mit der ersten Metallschicht (141),
- Aufbringen der transparenten Schicht (143), die in dem transparenten Material ausgeführt ist, in Kontakt mit der zweiten Metallschicht (142), wobei die dritte Schicht (143) die so genannte transparente Schicht ist,
- Bilden einer Einheit von Metallelementen (144), die in dem dritten Metall auf der transparenten Schicht (143) gegenüber der zweiten Metallschicht (142) ausgeführt sind.

**14.** Herstellungsverfahren nach Anspruch 12 oder 13,

wobei beim Schritt des Bildens der opaken Maske (140) die Maske auf der zweiten Seite des Trägers (110) angeordnet ist, um die elektromagnetische Strahlung ($\lambda$) für die wenigstens eine maskierte Struktur (122) und die an die wenigstens eine maskierte Struktur (122) angrenzenden Sensorstrukturen (123) zu verdecken.

**15.** Herstellungsverfahren nach einem der Ansprüche 12 bis 14, wobei weiter für jedes Metallelement (144) das Bilden eines Abschnitts einer vierten Schicht (145), so genannten transparenten vierten Schicht, vorgesehen ist, die in einem zweiten Material, so genannten transparenten zweiten Material, ausgeführt ist, und eines Abschnitts einer fünften Metallschicht (146), die in einem vierten Metall, das mit dem dritten Metall identisch oder davon verschieden ist, ausgeführt ist, um für jedes Metallelement (144) und ausgehend von der transparenten dritten Schicht (143) eine zweite aufeinanderfolgende Schichtung zu bilden aus: dem Metallelement (144), dem Abschnitt der transparenten vierten Schicht (145) und dem Abschnitt der fünften Metallschicht (146),

wobei das transparente zweite Material einen Brechungsindex kleiner oder gleich 2 in dem Wellenlängenbereich aufweist, und
wobei für jedes Metallelement (144) der Abschnitt der transparenten vierten Schicht (145) und der Abschnitt der fünften Metallschicht (146) eine zweite MIM-Struktur in dem Wellenlängenbereich bilden.

## Claims

**1.** Detection component (1) for detecting electromagnetic radiation ($\lambda$) in a wavelength range, comprising:

- a support (110) comprising a layer (120), called active layer, in which a plurality of structures (121a, 121b, 122, and 123) for detecting electromagnetic radiation ($\lambda$) in said wavelength range is arranged, with the support (110) comprising a first surface from which the active layer (120) extends, and a second surface opposite the first surface by which the support (110) is intended to receive the electromagnetic radiation ($\lambda$),
- at least one mask (140), called an opaque mask, arranged on a portion of the second surface of the support (110) to block the electromagnetic radiation for at least one of the detection structures (122), called a masked structure,

the detection component (1) **being characterized in that** the opaque mask (140) comprises at least a first, a second, and a third metal, and a material, called a transparent material, with a refractive index less than or equal to 2 in the wavelength range, the first metal having an extinction coefficient $k_{m1}$ greater than or equal to $5n_{m1}$, or even $10n_{m1}$, and each of the second and third metals having an extinction coefficient $k_{m2/3}$ strictly less than $5n_{m2/3}$, or even less than or equal to $2n_{m2/3}$, where $n_{m1}$ and $n_{m2/3}$ are the refractive indices of the first and each of the second and third metals in the wavelength range, the transparent material having an extinction coefficient $k_t$ less than or equal to 0.01,
wherein the opaque mask (140) comprises, starting from the second surface of the support (110), a successive stack of:

- a first metal layer (141) made of the first metal,
- a second metal layer (142) made of the second metal,
- a third layer (143), called a transparent layer, made of the transparent material, and
- an assembly of metal elements (144) made of the third metal, said assembly being arranged on the transparent layer (143) opposite the second metal layer (142),

and wherein the second metal layer (142), the transparent layer (143), and the assembly of metal elements (144) form MIM structures in the wavelength range.

**2.** Detection component (1) according to claim 1, wherein the second and third metals are identical.

**3.** Detection component (1) according to claim 1 or 2, wherein the first metal layer (141) has a thickness $h_{m1}$ more than 2 times greater than a skin depth $\delta_{m1}$ of the first metal in the wavelength range, with the thickness of the first metal layer (141) preferably being more than 4 times greater than the skin depth $\delta_{m1}$ of the first metal in the wavelength range.

**4.** Detection component (1) according to any one of claims 1 to 3, wherein the second metal layer (142) has a thickness $h_{m2}$ of between 0.5 times a skin depth $\delta_{m2}$ of the second metal in the wavelength range and 4 times the skin depth $\delta_{m2}$ of the second metal in the wavelength range, with the thickness of the first metal layer (141) preferably being more than 4 times greater than the skin depth $\delta_{m1}$ of the first metal in the wavelength range.

**5.** Detection component (1) according to claim 2, either alone or in combination with claims 3 or 4, wherein the metal elements (144) have at least one lateral dimension L, in a plane substantially parallel to the second surface, equal to or less than a value Lm

satisfying the following equation :

$$Lm = \frac{\lambda_0}{2\ n_d\sqrt{(1+\frac{2\delta_{m2}}{h_d})}}$$

where $\lambda_0$ is a central wavelength within the wavelength range, $n_d$ is a refractive index of the transparent material at said wavelength, $h_d$ is a thickness of the transparent layer, and $\delta_{m2}$ is a skin depth of the second metal at said wavelength,

the metal elements (144) preferably have a maximum lateral dimension and a minimal lateral dimension within a plane substantially parallel to the second surface, of between 0.75 times said value Lm and 1.25 times the value Lm.

**6.** Detection component (1) according to any one of claims 1 to 5, wherein in the assembly of metal elements (144), two adjacent metal elements have an inter-barycentric distance between them that is less than or equal to $\lambda_0/n_d$, where $\lambda_0$ is a central wavelength of the wavelength range and $n_d$ is the refractive index of the transparent material in the wavelength range, with the pitch P between two adjacent metal elements (144) in the assembly of the metal elements (144) is preferably less than 0.75 times $\lambda_0/n_d$.

**7.** Detection component (1) according to claim 6, wherein the metal elements (144) of the assembly of the metal elements (144) are arranged periodically with a pitch P between the metal elements (144) of less than $\lambda_0/n_d$, said pitch P between the metal elements (144) preferably being less than 0.75 times $\lambda_0/n_d$.

**8.** Detection component (1) according to any one of claims 1 to 6, wherein the transparent layer (143) has a thickness of between $\lambda_0/4n_d$ and $\lambda_0/50n_d$, inclusively, with $\lambda_0$ being a central wavelength in the wavelength range and $n_d$ being the refractive index of the transparent material (143) in the wavelength range.

**9.** Detection component (1) according to claim 2, either alone or in combination with any one of claims 3 to 8, wherein each metal element (144) of the assembly of the metal elements (144) has a thickness in the stacking direction of the opaque mask (140) that is between one times a skin depth $\delta_{m2}$ of the third metal in the wavelength range and three times said skin depth $\delta_{m2}$ of the second metal, with the thickness of each metal element preferably being between one and a half times the skin depth $\delta_{m2}$ of the third metal in the wavelength range and two and a half times said skin depth $\delta_{m2}$ of the third metal.

**10.** Detection component (1) according to any one of claims 1 to 9, wherein the opaque mask (140) is arranged on the second surface of the support (110) to block the electromagnetic radiation ($\lambda$) for the at least one masked structure (122) and the detection structures (123) adjacent to said at least one masked structure (122), with the mask preferably being arranged to also block the electromagnetic radiation ($\lambda$) of the detection structures (123) adjacent to said detection structures (123) adjacent to said at least one masked structure (122),
wherein the support (110) preferably has a thickness of less than 10 $\mu$m, with the opaque mask (140) extending, on either side of a projection of the masked structure (122), on the second surface of the support (110) over a distance greater than 15 $\mu$m or even greater than 30 $\mu$m.

**11.** Detection component (1) according to any one of claims 1 to 10, wherein the opaque mask further comprises a fourth metal, which is identical to or different from the third metal, and a second material, called a second transparent material, said second transparent material having a refractive index less than or equal to 2 in the wavelength range,

wherein, for each metal element, there is a second successive stack, starting from the third transparent layer, comprising:

- said metal element (144),
- a portion of the fourth layer (145), called fourth transparent layer, made of the second transparent material,
- a portion of the fifth metal layer (146) made of the fourth metal,

wherein, for each metal element (144), the portion of the fourth transparent layer (145) and the portion of the fifth metal layer (146) form a second MIM structure in the wavelength range.

**12.** Method for manufacturing a detection component (1) for detecting electromagnetic radiation ($\lambda$) in a wavelength range, said method comprising the following steps:

- providing a support (110) comprising a layer (120), called active layer, in which a plurality of structures (121a, 121b, 122, and 123) for detecting electromagnetic radiation ($\lambda$) in the said wavelength range is arranged, the support (110) comprising a first surface from which the active layer (120) extends, and a second surface opposite the first surface by which the support

(110) is intended to receive the electromagnetic radiation (λ),
- formation of an opaque mask (140) comprising, starting from the second surface of the support (110), a successive stack ofsupport:

o a first metal layer (141) made of a first metal,
o a second metal layer (142) made of a second metal,
o a third layer (143), called a transparent layer, made of a material, called a transparent material, with a refractive index less than or equal to 2 in the wavelength range, and
o an assembly of metal elements (144) made of a third metal, said assembly being arranged on the transparent layer (143) opposite the second metal layer (142), with the second metal layer (142), the transparent layer (143), and the assembly of the metal elements (144) forming MIM structures in the wavelength range,
the opaque mask (140) being arranged on a portion of the second surface of the support (110) to block the electromagnetic radiation for at least one of the detection structures (122), called a masked structure,
wherein method the opaque mask (140) comprises the first, the second, and the third metal, and the material, called a transparent material, with the first metal having an extinction coefficient km1 greater than or equal to $5n_{m1}$, or even $10n_{m1}$, and the second and third metals having an extinction coefficient $k_{m2/3}$ strictly less than $5n_{m2/3}$, or even less than or equal to $2n_{m2/3}$ with $n_{m1}$ and $n_{m2/3}$ being the respective refractive indices of the first and each of said second and third metals in the wavelength range, with the transparent material having an extinction coefficient $k_t$ less than or equal to 0.01.

**13.** Method for manufacturing according to claim 12, wherein the formation step comprises the following sub-steps:

- deposition of the first metal layer (141) made of the first metal in contact with the second surface of the support (110),
- deposition of the second metal layer (142) made of the second metal in contact with the first metal layer (141),
- deposition of the transparent layer (143) made of the transparent material in contact with the second metal layer (142), the third layer (143) being called a transparent layer,
- formation of an assembly of the metal elements (144) made of the third metal on the transparent layer (143) opposite the second metal layer (142).

**14.** Method for manufacturing according to claim 12 or 13, wherein, during the opaque mask (140) formation step, the mask is arranged on the second surface of the support (110) to block the electromagnetic radiation (λ) for the at least one masked structure (122) and the detection structures (123) adjacent to said at least one masked structure (122).

**15.** Method for manufacturing according to any one of claims 12 to 14, which further involves, for each metal element (144), the formation of a portion of the fourth layer (145), called a fourth transparent layer, made of a second material called a second transparent material, and a portion of the fifth metal layer (146) made of a fourth metal, different from or identical to the third metal, so as to form, for each metal element (144), a second successive stack, starting from the third transparent layer (143), of: the metal element (144), the portion of the fourth transparent layer (145), and the portion of the fifth metal layer (146),

wherein the second transparent material has a refractive index less than or equal to 2 in the wavelength range, and
wherein, for each metal element (144), the portion of the fourth transparent layer (145) and the portion of the fifth metal layer (146) form a second MIM structure in the wavelength range.

Fig. 1

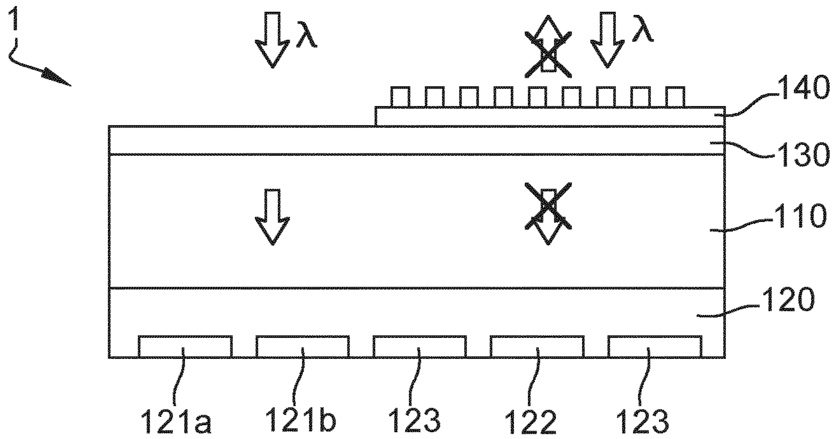


Fig. 2A

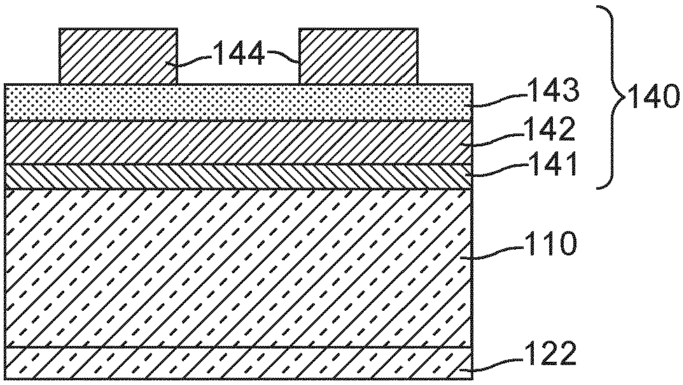


Fig. 2B

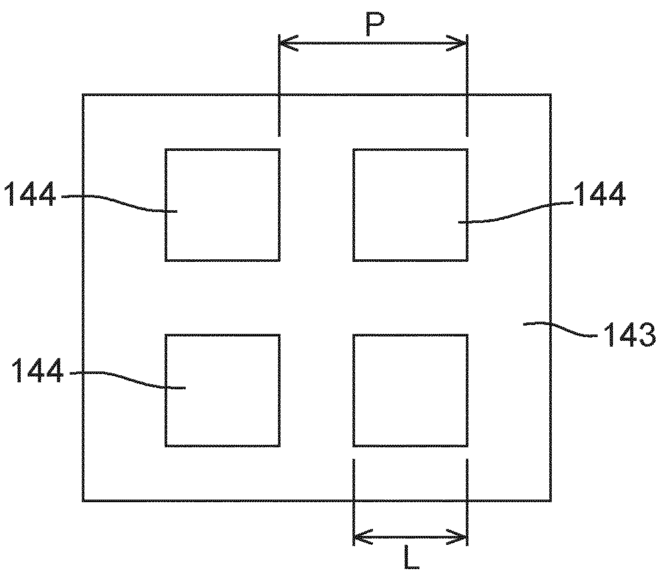

# Fig. 3A

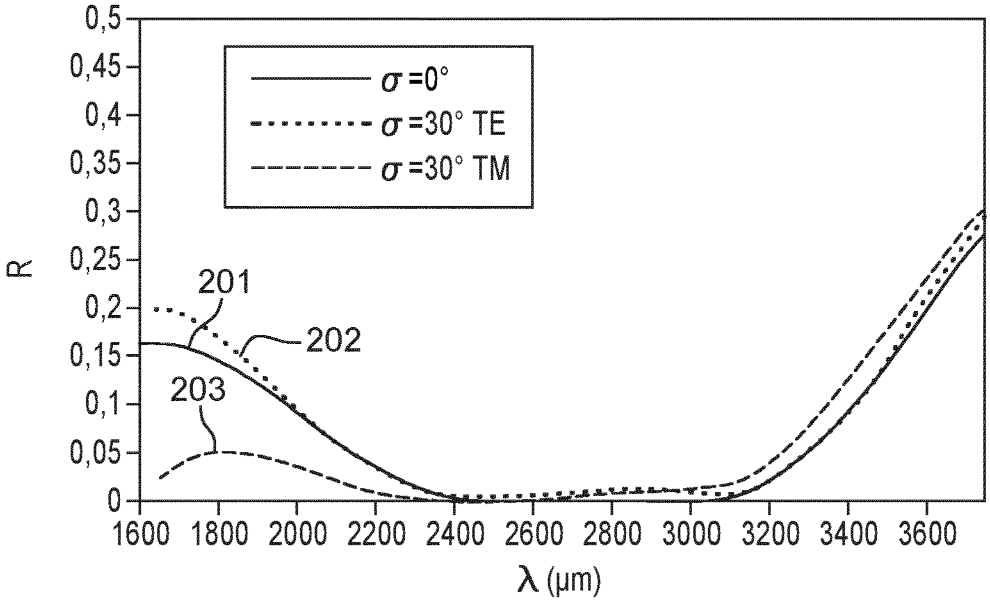
σ =0°
σ =30° TE
σ =30° TM
R
0,5
0,45
0,4
0,35
0,3
0,25
0,2
0,15
0,1
0,05
0
201
202
203
1600
1800
2000
2200
2400
2600
2800
3000
3200
3400
3600
λ (µm)

# Fig. 3B

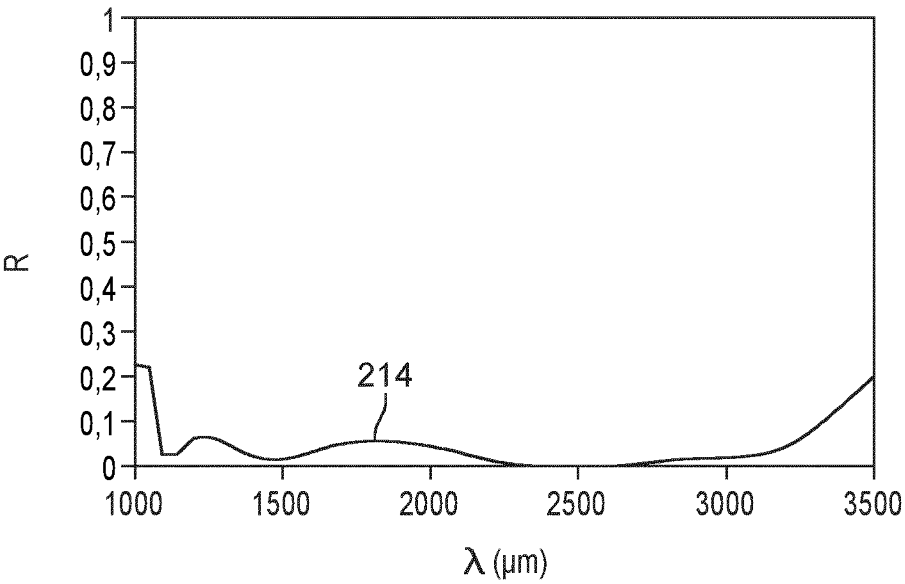
R
1
0,9
0,8
0,7
0,6
0,5
0,4
0,3
0,2
0,1
0
214
1000
1500
2000
2500
3000
3500
λ (µm)

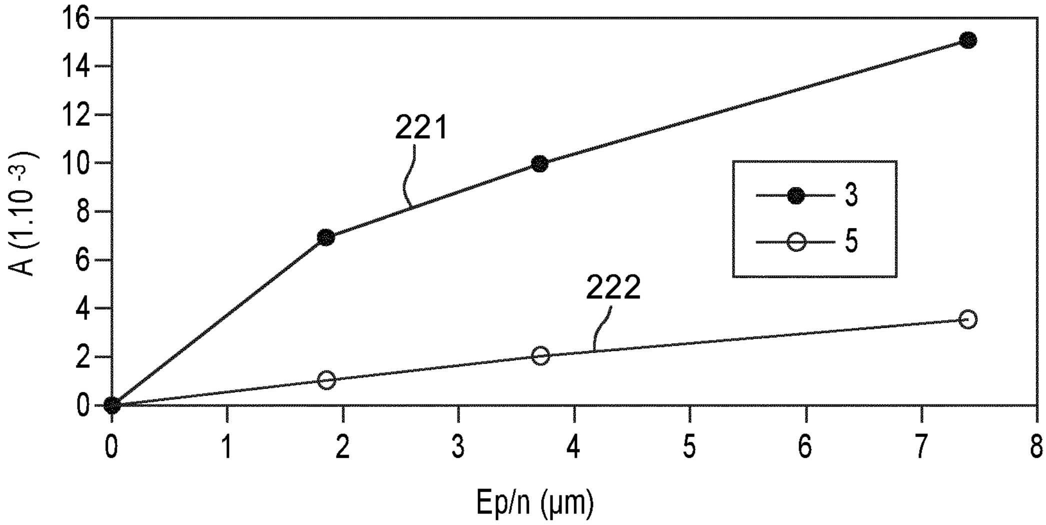
16
14
12
10
8
6
4
2
0
A (1.10 -3)
221
222
3
5
0
1
2
3
4
5
6
7
8
Ep/n (µm)

**Fig. 4**

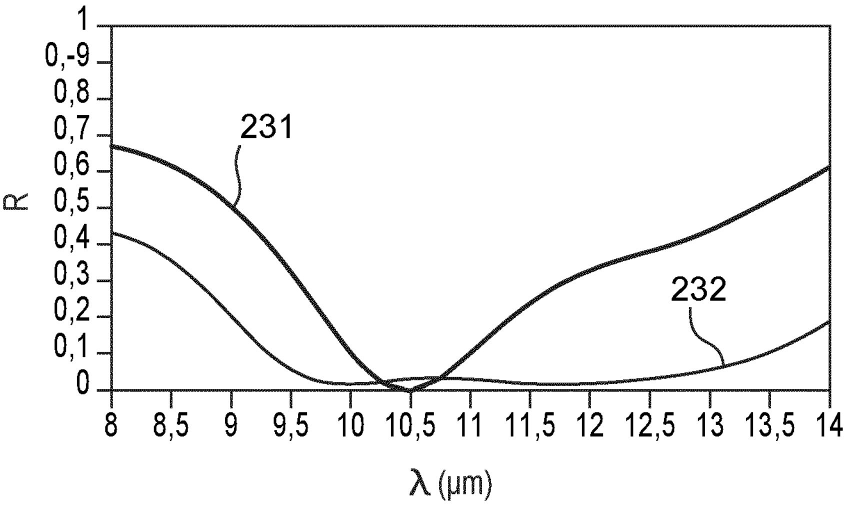
1
0,-9
0,8
0,7
0,6
0,5
0,4
0,3
0,2
0,1
0
R
231
232
8
8,5
9
9,5
10
10,5
11
11,5
12
12,5
13
13,5
14
λ (µm)

**Fig. 7**

**Fig. 5A**

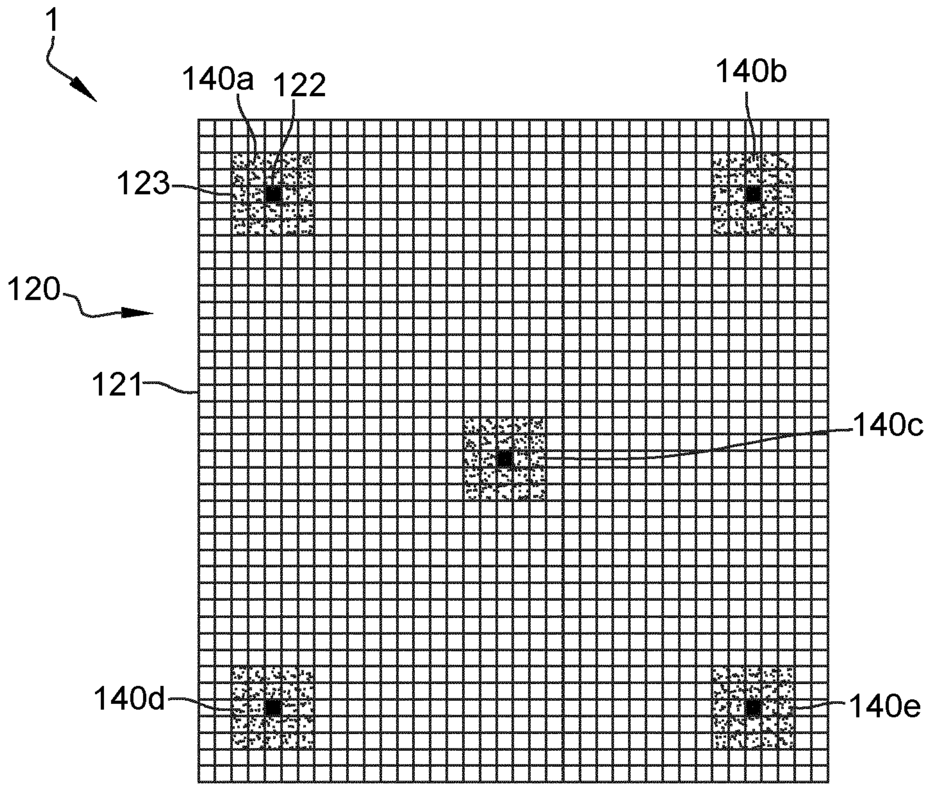


**Fig. 5B**

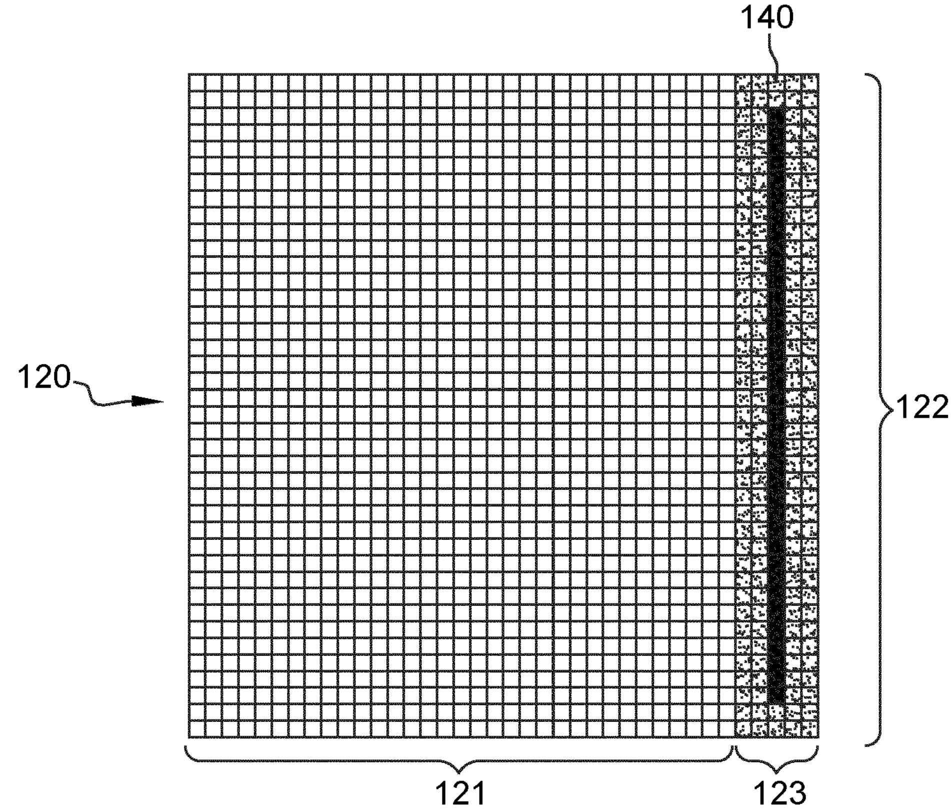

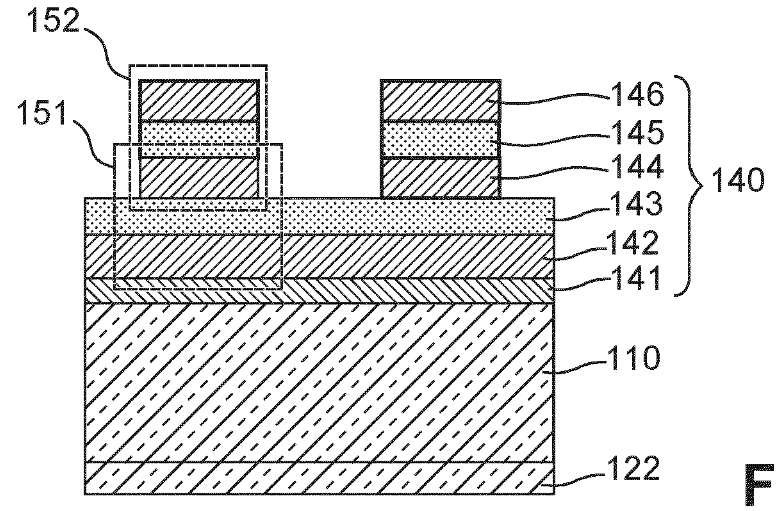
152
151
146
145
144
143
142
141
140
110
122

Fig.6A

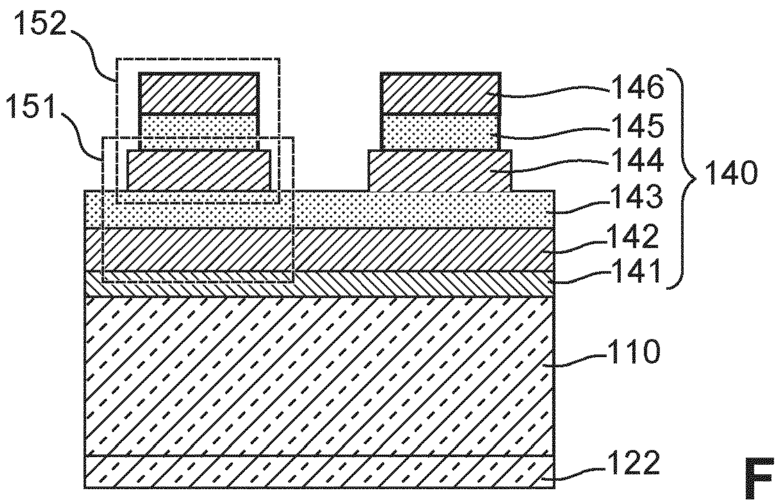
152
151
146
145
144
143
142
141
140
110
122

Fig.6B

## RÉFÉRENCES CITÉES DANS LA DESCRIPTION

*Cette liste de références citées par le demandeur vise uniquement à aider le lecteur et ne fait pas partie du document de brevet européen. Même si le plus grand soin a été accordé à sa conception, des erreurs ou des omissions ne peuvent être exclues et l'OEB décline toute responsabilité à cet égard.*

### Documents brevets cités dans la description


- US 10326952 B
- WO 2019004319 A


### Littérature non-brevet citée dans la description


- **2006 ; A.P. HIBBINS.** *Physical Review B,* (74), 073408